# EUROPEAN PATENT APPLICATION

(11) **EP 4 757 560 A1**
(43) Date of publication of application: **10.06.2026**
(21) Application number: 25203632.2
(22) Date of filing: 22.09.2025
(51) Int. Cl.: H10K 59/40, H10K 59/80

(54) **DISPLAY DEVICE AND ELECTRONIC DEVICE INCLUDING THE SAME**

(30) Priority: 03.12.2024 KR 20240177858; 14.01.2025 KR 20250005569
(71) Applicant: Samsung Display Co., Ltd., Yongin-si, Gyeonggi-do (KR)
(72) Inventor: GONG, Sucheol, Yongin-si (KR); KANG, Seulwoo, Yongin-si (KR); BAE, Kichul, Yongin-si (KR); LEE, Dong-Cheol, Yongin-si (KR)
(74) Representative: Marks & Clerk LLP

(57) **Abstract**

A display device includes a plurality of lower insulating layers on a substrate, a light-emitting element on the lower insulating layers, an encapsulation layer on the light-emitting element and including a plurality of insulating encapsulation layers, a base insulating layer on the encapsulation layer, a conductive pattern on the base insulating layer, and an upper insulating layer on the conductive pattern. The upper insulating layer is spaced from an edge of the substrate. At least one insulating layer among the lower insulating layers, the encapsulation layer, and the base insulating layer extends to the edge of the substrate. A first surface roughness of a first upper surface of the at least one insulating layer, without being covered by the upper insulating layer, is greater than a second surface roughness of a second upper surface of the at least one insulating layer covered by the upper insulating layer.

## Description

### BACKGROUND

### 1. Field

One or more embodiments of the present disclosure relate to a display device and an electronic device including the same.

### 2. Description of Related Art

Electronic devices, such as smartphones, digital cameras, notebook computers, navigation systems, and smart televisions, which generally provide images to a user, may include a display device for displaying images. The display device generates images and provides the generated images to the user through a display screen. The display device usually includes a display panel configured to display images and an input sensing unit arranged on the display panel and configured to sense external inputs.

However, the display devices may be vulnerable to external impact. For instance, when a display device is dropped to a floor, impact may be applied to a side portion of the display device, causing damage to the side portion of the display device. For example, the sides of some components of the input sensing unit may be delaminated from each other. Therefore, it is necessary and/or desired to develop technology to prevent or reduce damage to the side portion of display devices.

### SUMMARY

One or more aspects of embodiments of the present disclosure are directed toward a display device and an electronic device including the same, which are configured to prevent or reduce damage to the side portion of the display device. Additional aspects will be set forth in part in the description which follows and, in part, will be apparent from the description, or may be learned by practice of the presented embodiments.

According to one or more embodiments of the present disclosure, a display device includes a substrate, a plurality of lower insulating layers on (e.g., arranged on) the substrate, a light-emitting element on (e.g., arranged on) the lower insulating layers, an encapsulation layer on (e.g., arranged on) the light-emitting element and including a plurality of insulating encapsulation layers, a base insulating layer on (e.g., arranged on) the encapsulation layer, a conductive pattern on (e.g., arranged on) the base insulating layer, and an upper insulating layer on (e.g., arranged on) the conductive pattern, wherein the upper insulating layer may be spaced and/or apart (e.g., spaced apart or separated) from an edge of the substrate, at least one insulating layer selected from among the lower insulating layers, the insulating encapsulation layers, and the base insulating layer extends to the edge of the substrate, and a first surface roughness of a first upper surface of the at least one insulating layer, which is exposed upward without being covered by the upper insulating layer, is greater than a second surface roughness of a second upper surface of the at least one insulating layer covered by the upper insulating layer.

In one or more embodiments of the present disclosure, a display device includes a substrate, a plurality of lower insulating layers on (e.g., arranged on) the substrate, a light-emitting element on (e.g., arranged on) the lower insulating layers, an encapsulation layer on (e.g., arranged on) the light-emitting element and including a plurality of insulating encapsulation layers, a base insulating layer on (e.g., arranged on) the encapsulation layer, a conductive pattern on (e.g., arranged on) the base insulating layer, and an upper insulating layer on (e.g., arranged on) the conductive pattern, wherein: the upper insulating layer, the lower insulating layers, the insulating encapsulation layers, and the base insulating layer are spaced and/or apart (e.g., spaced apart or separated) from an edge of the substrate; edges of the upper insulating layer, the lower insulating layers, the insulating encapsulation layers, and the base insulating layer overlap one another; and a first surface roughness of a first upper surface of the substrate, which is exposed upward without being covered by the upper insulating layer, is greater than a second surface roughness of a second upper surface of the substrate covered by the upper insulating layer.

In one or more embodiments of the present disclosure, an electronic device includes a display device for providing an image to a user and a processor for processing an image signal and providing the image signal to the display device, wherein the display device includes a substrate, a plurality of lower insulating layers on (e.g., arranged on) the substrate, a light-emitting element on (e.g., arranged on) the lower insulating layers, an encapsulation layer on (e.g., arranged on) the light-emitting element and including a plurality of insulating encapsulation layers, a base insulating layer on (e.g., arranged on) the encapsulation layer, a conductive pattern on (e.g., arranged on) the base insulating layer, and an upper insulating layer on (e.g., arranged on) the conductive pattern, wherein: the upper insulating layer is spaced and/or apart (e.g., spaced apart or separated) from an edge of the substrate; at least one insulating layer selected from among the lower insulating layers, the insulating encapsulation layers, and the base insulating layer extends to the edge of the substrate; and a first surface roughness of a first upper surface of the at least one insulating layer, which is exposed upward without being covered by the upper insulating layer, is greater than a second surface roughness of a second upper surface of the at least one insulating layer covered by the upper insulating layer.

At least some of the above and other features of the invention are set out in the claims.

### BRIEF DESCRIPTION OF DRAWINGS

The accompanying drawings are included to provide a further understanding of the present disclosure and are incorporated in and constitute a part of this disclosure. The drawings illustrate embodiments of the present disclosure and, together with the description, serve to explain principles of the disclosure. Above and/or other aspects of the disclosure should become apparent and appreciated from the following description of embodiments taken in conjunction with the accompanying drawings. In the drawings:
FIG. 1 is a block diagram of an electronic device according to one or more embodiments of the present disclosure;
FIG. 2 illustrates schematic diagrams of electronic devices according to one or more suitable embodiments of the present disclosure;
FIG. 3 is a perspective view of an electronic device according to one or more embodiments of the present disclosure;
FIG. 4 is an exploded perspective view of the electronic device illustrated in FIG. 3 according to one or more embodiments of the present disclosure;
FIG. 5 illustrates a cross section of a display device illustrated in FIG. 4 according to one or more embodiments of the present disclosure;
FIG. 6 illustrates a cross section of a display panel illustrated in FIG. 5 according to one or more embodiments of the present disclosure;
FIG. 7 is a plan view of the display panel illustrated in FIG. 5 according to one or more embodiments of the present disclosure;
FIG. 8 illustrates a cross section of a display panel and an input sensing unit corresponding to any one pixel illustrated in FIG. 7 according to one or more embodiments of the present disclosure;
FIG. 9 is a plan view of the input sensing unit illustrated in FIG. 5 according to one or more embodiments of the present disclosure;
FIG. 10 is an enlarged view of two adjacent first sensing units and two adjacent second sensing units illustrated in FIG. 9 according to one or more embodiments of the present disclosure;
FIG. 11 is a cross-sectional view taken along the line A-A' illustrated in FIG. 10 according to one or more embodiments of the present disclosure;
FIG. 12 is a cross-sectional view taken along the line I-I' illustrated in FIG. 7 according to one or more embodiments of the present disclosure;
FIG. 13 is a cross-sectional view taken along the line II-II' illustrated in FIG. 7 according to one or more embodiments of the present disclosure;
FIG. 14 illustrates a cross-sectional configuration of a comparative display device;
FIG. 15 schematically illustrates a configuration of the display device illustrated in FIG. 12 according to one or more embodiments of the present disclosure;
FIG. 16 illustrates external impact test results for the comparative display device illustrated in FIG. 14 and the display device illustrated in FIG. 15 according to present disclosure;
FIG. 17 illustrates a planar configuration of a mother panel including the display panel illustrated in FIG. 7 according to one or more embodiments of the present disclosure;
FIG. 18 is an enlarged view of any one unit panel illustrated in FIG. 17 according to one or more embodiments of the present disclosure;
FIGS. 19A - 19D are cross-sectional views taken along the line III-III' illustrated in FIG. 18 and explain a method for manufacturing a display device according to one or more embodiments of the present disclosure;
FIG. 20 illustrates test results regarding the adhesive force between a third insulating encapsulation layer and a cover layer according to the present disclosure;
FIGS. 21 - 25 illustrate portions of insulating layers each having a first upper surface formed thereon according to embodiments of the present disclosure;
FIG. 26 illustrates a configuration on a unit panel according to one or more embodiments of the present disclosure;
FIG. 27A is a cross-sectional view taken along the line IV-IV' of FIG. 26 according to one or more embodiments of the present disclosure;
FIG. 27B illustrates a unit panel formed by cutting along the cutting line illustrated in FIG. 26A according to one or more embodiments of the present disclosure;
FIG. 28 illustrates a configuration on a unit panel according to one or more embodiments of the present disclosure;
FIG. 29A is a cross-sectional view taken along the line V-V' of FIG. 28 according to one or more embodiments of the present disclosure;
FIG. 29B illustrates a unit panel formed by cutting along the cutting line illustrated in FIG. 29A according to one or more embodiments of the present disclosure; and
FIG. 30 illustrates a configuration on a unit panel according to one or more embodiments of the present disclosure.

### DETAILED DESCRIPTION

Embodiments of the present disclosure may be modified and practiced in many alternate forms, and thus example embodiments will be exemplified in the drawings and described in more detail. It should be understood, however, that it is not intended to limit the disclosure to the particular forms disclosed, but rather, is intended to cover all modifications, equivalents, and alternatives falling within the scope of the disclosure.

In this disclosure, it will be understood that if (e.g., when) an element (or region, layer, portion, and/or the like) is referred to as being "on", "connected to" or "coupled to" another element, it can be directly on, connected or coupled to the other element, or one or more intervening elements may be present therebetween. In contrast, "directly on" may refer to that there are no additional intervening elements or layers between the element or layer and the other element or layer. In addition, if (e.g., when) a layer, a film, a region, a plate, and/or the like is referred to as being "under" or "below" another part, it may be "directly under" the other part, or one or more intervening layers may be present therebetween. Also, if (e.g., when) an element is referred to as being arranged "on" another element, it may be arranged under the other element.

Like reference numerals refer to like elements throughout the disclosure, and duplicative descriptions thereof may not be provided for conciseness. In addition, in the drawings, the thicknesses, ratios, and dimensions of elements may be exaggerated for effective description of the technical contents. As used herein, the term "and/or" or "or" may include any and all combinations that the associated configurations can define.

Although the terms "first," "second," and/or the like may be used herein to describe one or more suitable components, these components should not be limited by these terms. These terms are used only to distinguish one component, part, region, layer, or portion from another component, part, region, layer, or portion. For example, without departing from the scope and teachings of disclosure, a first component, a first part, a first region, a first layer, or a first portion may be referred to as a second component, a second part, a second region, a second layer, or a second portion, and similarly, a second component, a second part, a second region, a second layer, or a second portion may also be referred to as a first component, a first part, a first region, a first layer, or a first portion. Singular expressions include plural expressions unless the context clearly indicates otherwise. For example, the singular forms, "a," "an," and "the" are intended to include the plural forms as well, unless the context clearly indicates otherwise. Further, the use of "may" when describing embodiments of the present disclosure refers to "one or more embodiments of the present disclosure."

In addition, terms, such as "below", "lower", "above", "upper", and/or the like, are used herein for ease of description to describe one element's relation to another element(s) as illustrated in the drawings. The above terms are relative concepts and are described based on the directions indicated in the drawings.

It will be understood that the terms "comprise(s)/comprising" and/or "include(s)/including" and/or "have(has)/having", if (e.g., when) used in this disclosure, specify the presence of stated features, numbers, steps, operations, elements, components, and/or groups thereof, but do not preclude the presence or addition of one or more other features, numbers, steps, operations, elements, components, and/or groups thereof. Additionally, the terms "comprise(s)/comprising," "include(s)/including," "has(have)/having", or other similar terms include or support the terms "consisting of" and "consisting essentially of," indicating the presence of stated features, numbers, steps, operations, parts, and/or components, without or essentially without the presence of other features, numbers, steps, operations, parts, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the disclosure will be described with reference to the drawings.

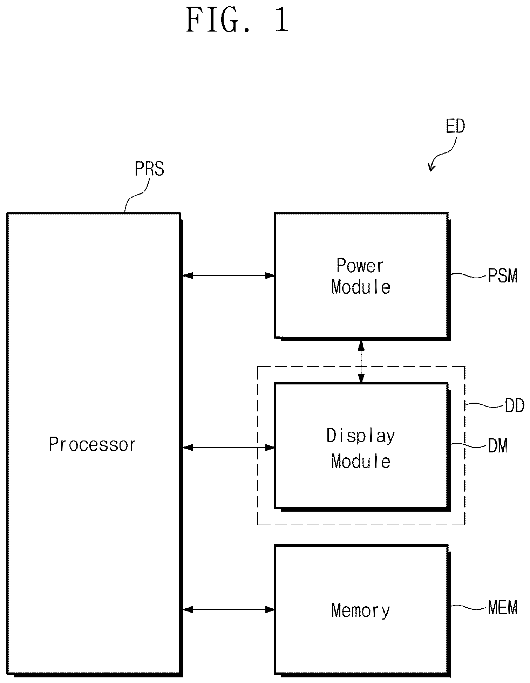

FIG. 1 is a block diagram of an electronic device according to one or more embodiments of the present disclosure.

Referring to FIG. 1, an electronic device ED according to one or more embodiments of the disclosure includes a display device DD for providing an image to a user and may further include a module or a device having an additional function in addition to the display device DD. The electronic device ED according to one or more embodiments of the disclosure may include a display module DM, a processor PRS, a memory MEM, and a power module PSM, and the display device DD may include the display module DM.

The processor PRS may include at least one of a central processing unit (CPU), an application processor (AP), a graphic processing unit (GPU), a communication processor (CP), an image signal processor (ISP), or a controller. The processor PRS may process an image signal and provide the image signal to the display device DD, and the display device DD may generate an image corresponding to the image signal.

In one or more embodiments of the disclosure, the processor PRS may be provided by being divided into two or more parts from a functional or structural perspective. For example, in one or more embodiments, the processor PRS may include a main processor in the form of a first driving chip including a central processing unit and an auxiliary processor in the form of a second driving chip including a controller configured to receive an image signal from the main processor and process the image signal to match an interface specification of the display module DM.

The memory MEM may store data information necessary for an operation of the processor PRS or the display module DM. When the processor PRS executes an application stored in the memory MEM, an image data signal and/or an input control signal may be transmitted to the display module DM, and the display module DM may process the received signal and output image information through a display screen.

The power module PSM may include a power supply module, such as a power adapter and/or a battery device, and a power conversion module configured to convert power supplied by the power supply module and generate power necessary for an operation of the electronic device ED. The power module PSM may supply power to the display module DM and the processor PRS.

At least one of (e.g., at least one selected from among) the components of the electronic device ED described above may be included in the display device DD according to the above-described embodiments of the disclosure. In one or more embodiments, some of the individual modules functionally included in one module may be included in the display device DD while others may be provided independently of the display device DD. For example, in one or more embodiments, the display device DD may include the display module DM, while the processor PRS, the memory MEM, and the power module PSM may be provided in the form of other devices within the electronic device ED, independently of the display device DD.

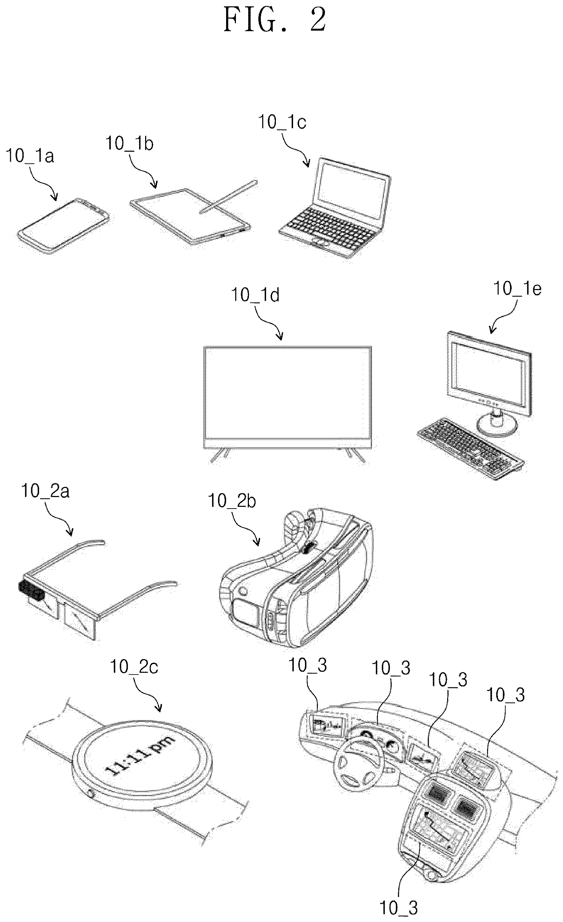

FIG. 2 illustrates schematic diagrams of electronic devices according to one or more embodiments of the present disclosure.

Referring to FIG. 2, the display device DD according to one or more embodiments of the disclosure may be applied to one or more suitable electronic devices. For example, the one or more suitable electronic devices to which the display device DD according to one or more embodiments of the disclosure is applied may include electronic devices for displaying images, such as a smart phone 10_1a, a tablet PC 10_1b, a laptop 10_1c, a TV 10_1d, or a desktop monitor 10_1e.

In addition, the one or more suitable electronic devices to which the display device DD according to one or more embodiments of the disclosure is applied may include wearable electronic devices such as smart glasses 10_2a, a head mounted display 10_2b, or a smart watch 10_2c. In addition, the one or more suitable electronic devices to which the display device DD according to one or more embodiments of the disclosure is applied may include vehicle electronic devices 10_3, such as a car dashboard, a center fascia, a center information display (CID) arranged on the dashboard, or a room mirror display.

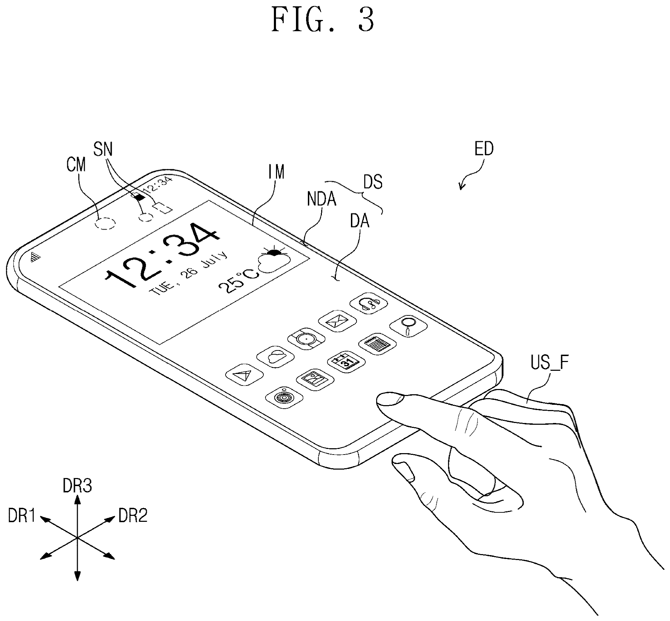

FIG. 3 is a perspective view of an electronic device according to one or more embodiments of the present disclosure.

Referring to FIG. 3, the electronic device ED according to one or more embodiments of the disclosure may have long sides extending in a first direction DR1 and short sides extending in a second direction DR2 crossing the first direction DR1. In one or more embodiments, the corners of the electronic device ED may have a round shape. This shape may be defined as a round-cornered tetragonal shape. For example, the electronic device ED illustrated in FIG. 3 may be the smartphone 10_1a illustrated in FIG. 2.

Hereinafter, a direction substantially normal (e.g., perpendicular) to a plane defined by the first direction DR1 and the second direction DR2 is defined as a third direction DR3. In addition, in this disclosure, the meaning of "when viewed on a plane" or "in plan view" is defined as a state viewed from the third direction DR3.

An upper surface of the electronic device ED may be defined as a display surface DS and have a plane defined by the first direction DR1 and the second direction DR2. Images IM generated by the electronic device ED may be provided to a user through the display surface DS. The electronic device ED may sense a touch by a user's hand US_F.

The display surface DS may include a display region DA and a non-display region NDA around (e.g., surrounding) the display region DA. The display region DA may display an image, and the non-display region NDA may not display an image. The non-display region NDA may be around (e.g., surround) the display region DA and define an edge of the electronic device ED, which may be printed in a set or predetermined color.

The electronic device ED may include a plurality of sensors SN and at least one camera CM. The sensors SN and the camera CM may be adjacent to the edge of the electronic device ED. In one or more embodiments, the sensors SN and the camera CM may be arranged in the display region DA adjacent to the non-display region NDA. For example, in one or more embodiments, the sensors SN may be proximity sensors, but the types (kinds) of sensors SN are not limited thereto. The camera CM may capture an external image.

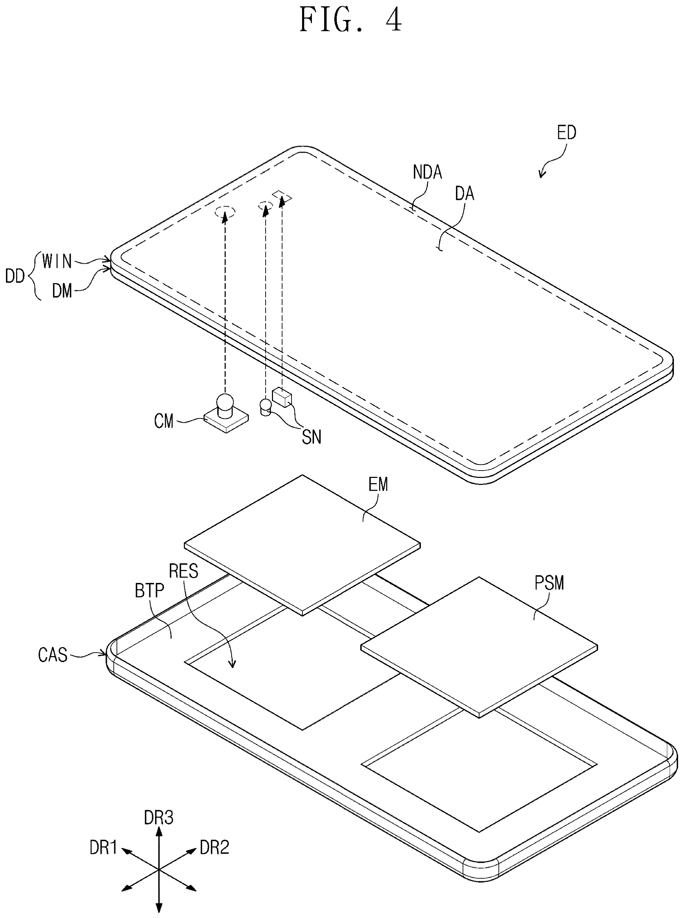

FIG. 4 is an exploded perspective view of the electronic device illustrated in FIG. 3 according to one or more embodiments of the present disclosure.

Referring to FIG. 4, the electronic device ED may include a display device DD, a camera CM, sensors SN, an electronic module EM, a power module PSM, and a case CAS.

The display device DD may have long sides extending in the first direction DR1 and short sides extending in the second direction DR2 crossing the first direction DR1. The display device DD may have a round-cornered tetragonal shape so as to correspond to the shape of the electronic device ED.

The display device DD may include a display region DA and a non-display region NDA around (e.g., surrounding) the display region DA. The display region DA may display an image, and the non-display region NDA may not display an image. The display region DA and the non-display region NDA of the display device DD may respectively correspond to the display region DA and the non-display region NDA of the electronic device ED illustrated in FIG. 3.

The display device DD may include a display module DM and a window WIN arranged on the display module DM. The display module DM may generate an image. The window WIN may protect the display module DM from external scratches and impacts. The image generated in the display module DM may be transmitted through the window WIN and provided to a user.

Each of the display module DM and the window WIN may include a display region DA that displays an image and a non-display region NDA that surrounds the display region DA and does not display an image. The display region DA and the non-display region NDA of each of the display module DM and the window WIN may correspond to the display region DA and the non-display region NDA of the display device DD, respectively.

A first hole region and second hole regions may be defined in the display device DD. Although not illustrated, a hole may be defined in each of the first and second hole regions. The hole may be defined in the display module DM. The camera CM may be arranged in a hole defined in the first hole region, and the sensors SN may be arranged in holes defined in the second hole regions.

The electronic module EM and the power module PSM may be arranged below the display device DD. In one or more embodiments, the electronic module EM and the power module PSM may be connected to each other through a separate flexible circuit board. The electronic module EM may control an operation of the display device DD. The electronic module EM may include the processor PRS described above. The power module PSM may supply power to the electronic module EM and the display module DM.

The case CAS may accommodate the display device DD, the camera CM, the sensors SN, the electronic module EM, and the power module PSM. The case CAS may protect the display device DD, the camera CM, the sensors SN, the electronic module EM, and the power module PSM. The electronic module EM and the power module PSM may be respectively arranged in recessed portions RES defined in a bottom portion BTP of the case CAS.

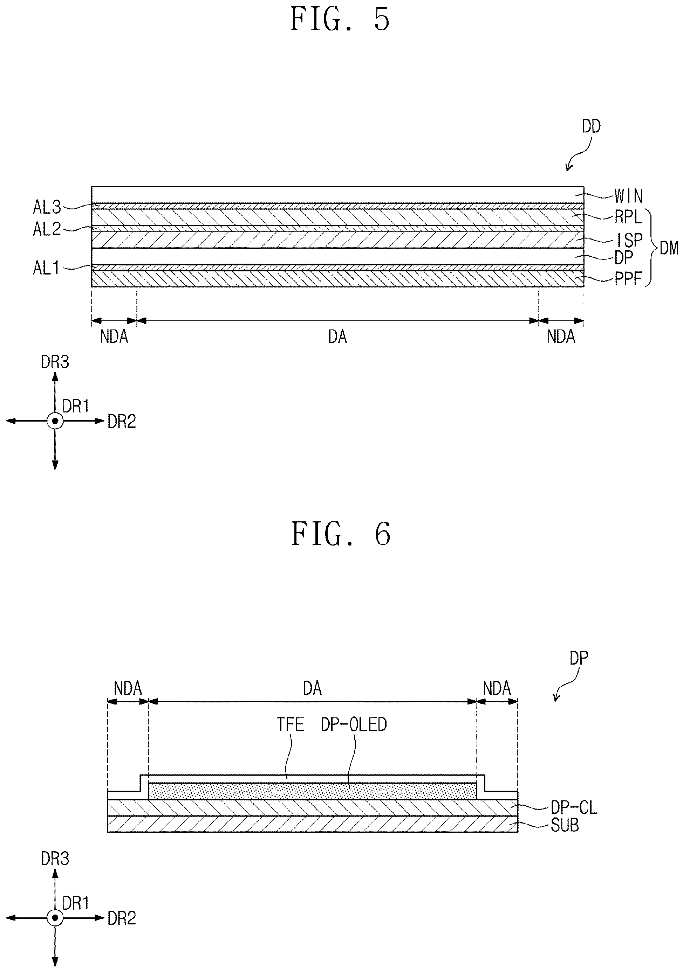

FIG. 5 illustrates a cross section of the display device illustrated in FIG. 4 according to one or more embodiments of the present disclosure.

As an example, FIG. 5 illustrates a cross section of the display device DD viewed from the first direction DR1.

Referring to FIG. 5, the display device DD may include a display panel DP, an input sensing unit ISP, a reflection prevention layer RPL, a window WIN, a panel protection film PPF, and first, second, and third adhesive layers AL1, AL2, and AL3. The display module DM may include the display panel DP, the input sensing unit ISP, the reflection prevention layer RPL, and the panel protection film PPF.

The display panel DP according to one or more embodiments of the disclosure may be a light-emitting display panel. For example, the display panel DP may be an organic light-emitting display panel or an inorganic light-emitting display panel. A light-emitting layer of the organic light-emitting display panel may include an organic light-emitting material. A light-emitting layer of the inorganic light-emitting display panel may include a quantum dot, a quantum rod, and/or the like. Hereinafter, as an example, the display panel DP will be described as an organic light-emitting display panel.

The input sensing unit ISP may be arranged on the display panel DP. In one or more embodiments, the input sensing unit ISP may include a plurality of sensing units for sensing an external input by a capacitive method. The input sensing unit ISP may be manufactured directly on the display panel DP when the display device DD is manufactured. Without being limited thereto, however, the input sensing unit ISP may be manufactured as a panel separate from the display panel DP and then attached to the display panel DP by an adhesive layer.

The reflection prevention layer RPL may be arranged on the input sensing unit ISP. The reflection prevention layer RPL may be defined as an external light reflection prevention film. The reflection prevention layer RPL may reduce the reflectance of external light incident from above the display device DD toward the display panel DP. The external light may not be visible to a user due to the reflection prevention layer RPL.

When external light traveling toward the display panel DP is reflected by the display panel DP like a mirror and provided back to a user, the user may visually recognize the external light. In order to prevent or reduce such a phenomenon, in one or more embodiments, the reflection prevention layer RPL may include a plurality of color filters that display the same colors as light emitted from pixels of the display panel DP.

The color filters may filter external light into the same colors as the light emitted from the pixels PX. As a result, the external light may not be visible to the user. Without being limited thereto, however, the reflection prevention layer RPL may include a retarder and/or a polarizer to reduce the reflectance of external light.

The window WIN may be arranged on the reflection prevention layer RPL. The window WIN may protect the display panel DP, the input sensing unit ISP, and the reflection prevention layer RPL from external scratches and impacts.

The panel protection film PPF may be arranged below the display panel DP. The panel protection film PPF may protect a lower portion of the display panel DP. The panel protection film PPF may include a flexible plastic material such as polyethylene terephthalate (PET).

The first adhesive layer AL1 is arranged between the display panel DP and the panel protection film PPF, and the display panel DP and the panel protection film PPF may be bonded to each other by the first adhesive layer AL1. The second adhesive layer AL2 is arranged between the input sensing unit ISP and the reflection prevention layer RPL, and the input sensing unit ISP and the reflection prevention layer RPL may be bonded to each other by the second adhesive layer AL2. The third adhesive layer AL3 is arranged between the window WIN and the reflection prevention layer RPL, and the window WIN and the reflection prevention layer RPL may be bonded to each other by the third adhesive layer AL3.

FIG. 6 illustrates a cross section of the display panel illustrated in FIG. 5 according to one or more embodiments of the present disclosure.

As an example, FIG. 6 illustrates a cross section of the display panel DP viewed from the first direction DR1.

Referring to FIG. 6, the display panel DP may include a substrate SUB, a circuit element layer DP-CL arranged on the substrate SUB, a display element layer DP-OLED arranged on the circuit element layer DP-CL, and an encapsulation layer TFE arranged on the display element layer DP-OLED.

The substrate SUB may include a display region DA and a non-display region NDA around (e.g., surrounding) the display region DA. The substrate SUB may include a flexible plastic (e.g., polymer) material such as polyimide (PI). The display element layer DP-OLED may be arranged on the display region DA.

A plurality of pixels may be arranged in the circuit element layer DP-CL and the display element layer DP-OLED. Each of the pixels may include a transistor arranged in the circuit element layer DP-CL and a light-emitting element arranged in the display element layer DP-OLED and connected to the transistor.

The encapsulation layer TFE may be arranged on the circuit element layer DP-CL so as to cover the display element layer DP-OLED. The encapsulation layer TFE may protect the pixels from moisture, oxygen, and external foreign substances.

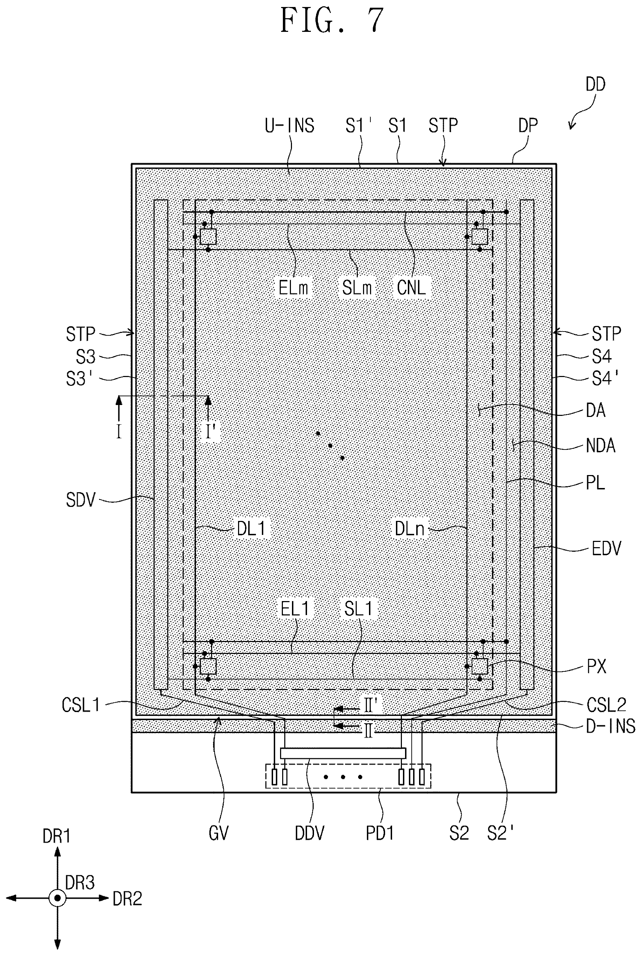

FIG. 7 is a plan view of the display panel illustrated in FIG. 5 according to one or more embodiments of the present disclosure.

Referring to FIG. 7, the display device DD may include a display panel DP, a scan driver SDV, a data driver DDV, a light-emitting driver EDV, and a plurality of first pads PD1.

The display panel DP may have a tetragonal shape having long sides extending in the first direction DR1 and short sides extending in the second direction DR2. The display panel DP may include a display region DA and a non-display region NDA around (e.g., surrounding) the display region DA.

The display panel DP may include a plurality of pixels PX, a plurality of scan lines SL1 to SLm, a plurality of data lines DL1 to DLn, a plurality of light-emitting lines EL1 to ELm, first and second control lines CSL1 and CSL2, a power line PL, and a plurality of connection lines CNL, wherein m and n are each a natural number.

The pixels PX may be arranged in the display region DA. The scan driver SDV and the light-emitting driver EDV may be separately arranged in the non-display region NDA adjacent to one of the long sides of the display panel DP. The data driver DDV may be arranged in the non-display region NDA adjacent to any one of the short sides of the display panel DP. When viewed on a plane (e.g., in plan view), in one or more embodiments, the data driver DDV may be adjacent to a lower end of the display panel DP.

The scan lines SL1 to SLm may extend in the second direction DR2 to be connected to the respective pixels PX and the scan driver SDV. The data lines DL1 to DLn may extend in the first direction DR1 to be connected to the respective pixels PX and the data driver DDV. The light-emitting lines EL1 to ELm may extend in the second direction DR2 to be connected to the respective pixels PX and the light-emitting driver EDV.

The power line PL may extend in the first direction DR1 to be arranged in the non-display region NDA. In one or more embodiments, the power line PL may be arranged between the display region DA and the light-emitting driver EDV, but embodiments of the present disclosure are not limited thereto, the power line PL may be arranged between the display region DA and the scan driver SDV.

The connection lines CNL may extend in the second direction DR2 and be arranged in the first direction DR1 to be connected to the power line PL and the pixels PX. A driving voltage may be applied to the pixels PX through the power line PL and the connection lines CNL that are connected to each other.

The first control line CSL1 may be connected to the scan driver SDV and extend toward the lower end of the display panel DP. The second control line CSL2 may be connected to the light-emitting driver EDV and extend toward the lower end of the display panel DP. The data driver DDV may be arranged between the first control line CSL1 and the second control line CSL2.

The first pads PD1 may be arranged in the non-display region NDA adjacent to the lower end of the display panel DP and may be closer to the lower end of the display panel DP than the data driver DDV. The data driver DDV, the power line PL, the first control line CSL1, and the second control line CSL2 may be connected to the first pads PD1. The data lines DL1 to DLn may be connected to the data driver DDV, and the data driver DDV may be connected to the first pads PD1 corresponding to the data lines DL1 to DLn.

In one or more embodiments, the display device DD may further include a timing controller for controlling the operation of the scan driver SDV, the data driver DDV, and the light-emitting driver EDV. The timing controller may be mounted on a printed circuit board and connected to the first pads PD1 through the printed circuit board.

The scan driver SDV may generate a plurality of scan signals, and the scan signals may be applied to the pixels PX through the scan lines SL1 to SLm. The data driver DDV may generate a plurality of data voltages, and the data voltages may be applied to the pixels PX through the data lines DL1 to DLn. The light-emitting driver EDV may generate a plurality of light-emitting signals, and the light-emitting signals may be applied to the pixels PX through the light-emitting lines EL1 to ELm.

The pixels PX may receive the data voltages in response to the scan signals. The pixels PX may display an image by emitting light having a brightness corresponding to the data voltages in response to the light-emitting signals.

The display device DD may include an upper insulating layer U-INS and a dummy insulating layer D-INS arranged above (e.g., on) the display panel DP. For example, the upper insulating layer U-INS and the dummy insulating layer D-INS are illustrated in gray in FIG. 7. In one or more embodiments, an insulating tape may be arranged on the data driver DDV.

When viewed on a plane (e.g., in plan view), an edge of the display panel DP may include a first side S1, a second side S2, a third side S3, and a fourth side S4. The first side S1 and the second side S2 may define the short sides of the tetragonal shape of the display panel DP and extend in the second direction DR2. The third side S3 and the fourth side S4 may define the long sides of the tetragonal shape of the display panel DP and extend in the first direction DR1.

The first side S1 may be defined as an upper side of the display panel DP, and the second side S2 may be defined as a lower side of the display panel DP. The third side S3 may be defined as a left side of the display panel DP, and the fourth side S4 may be defined as a right side of the display panel DP.

When viewed on a plane (e.g., in plan view), the upper insulating layer U-INS may have a tetragonal shape having long sides extending in the first direction DR1 and short sides extending in the second direction DR2. The upper insulating layer U-INS may have an area larger than that of the display region DA. The upper insulating layer U-INS may be arranged further inward than the edge of the display panel DP. An edge of the upper insulating layer U-INS may be spaced and/or apart (e.g., spaced apart or separated) from the edge of the display panel DP and arranged further inward than the edge of the display panel DP.

The edge of the upper insulating layer U-INS may include a first side S1', a second side S2', a third side S3', and a fourth side S4'. The first side S1' and the second side S2' may define the short sides of the tetragonal shape of the upper insulating layer U-INS and extend in the second direction DR2. The third side S3' and the fourth side S4' may define the long sides of the tetragonal shape of the upper insulating layer U-INS and extend in the first direction DR1.

The first side S1' may be defined as an upper side of the upper insulating layer U-INS, and the second side S2' may be defined as a lower side of the upper insulating layer U-INS. The third side S3' may be defined as a left side of the upper insulating layer U-INS, and the fourth side S4' may be defined as a right side of the upper insulating layer U-INS.

The first side S1, the second side S2, the third side S3, and the fourth side S4 may be spaced and/or apart (e.g., spaced apart or separated) from the first side S1', the second side S2', the third side S3', and the fourth side S4', respectively. A distance between the second side S2 and the second side S2' may be greater than a distance between the first side S1 and the first side S1', a distance between the third side S3 and the third side S3', and a distance between the fourth side S4 and the fourth side S4'.

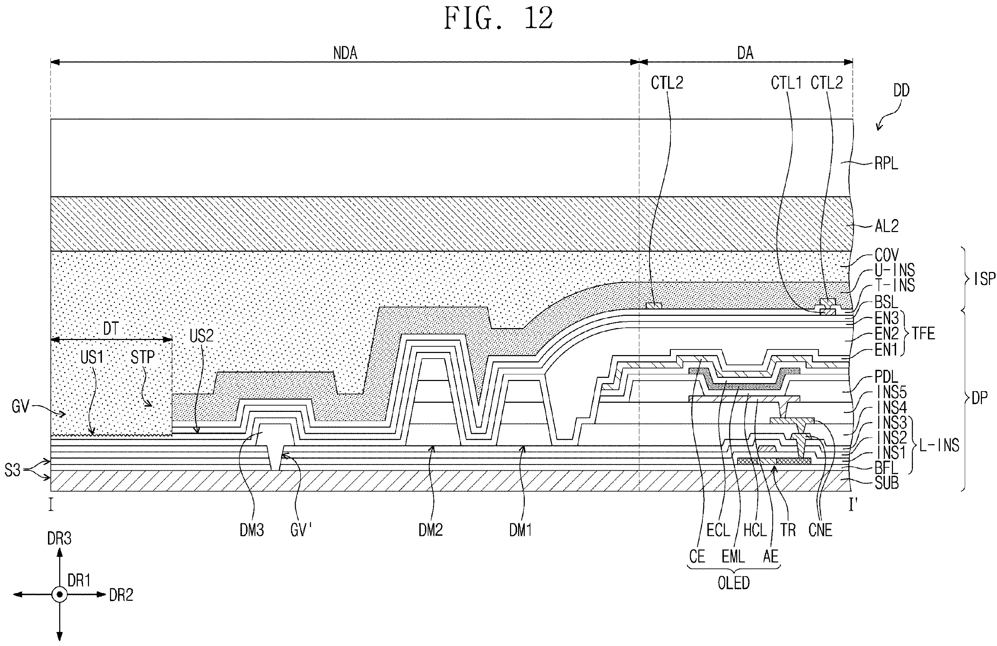

When viewed on a plane (e.g., in plan view), a step portion STP may be defined by the first side S1, the third side S3, and the fourth side S4 of the display panel DP and the first side S1', the third side S3', and the fourth side S4' of the upper insulating layer U-INS. A cross-sectional shape of the step portion STP will be illustrated in FIG. 12.

When viewed on a plane (e.g., in plan view), the dummy insulating layer D-INS may be arranged between the upper insulating layer U-INS and the second side S2 of the display panel DP. The second side S2 of the display panel DP may be defined as a lower side of the substrate SUB. Therefore, the dummy insulating layer D-INS may be arranged between the upper insulating layer U-INS and the lower side of the substrate SUB. The dummy insulating layer D-INS may be spaced and/or apart (e.g., spaced apart or separated) from the second side S2 and arranged between the data driver DDV and the second side S2' of the upper insulating layer U-INS.

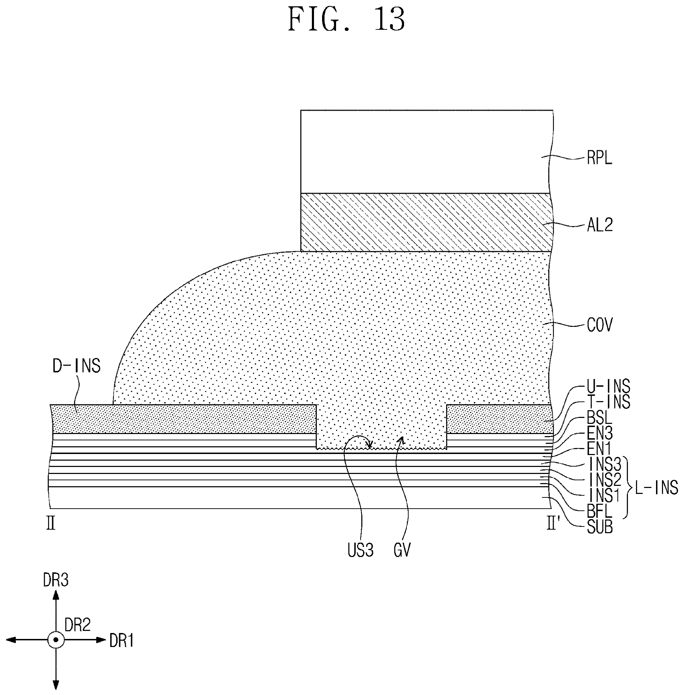

A groove GV may be defined between the dummy insulating layer D-INS and the upper insulating layer U-INS. The groove GV may extend in the second direction DR2. A cross-sectional shape of the groove GV will be illustrated in FIG. 13. The step portion STP and the groove GV may be defined continuously to have a tetragonal closed loop shape and may be around (e.g., surround) the display region DA.

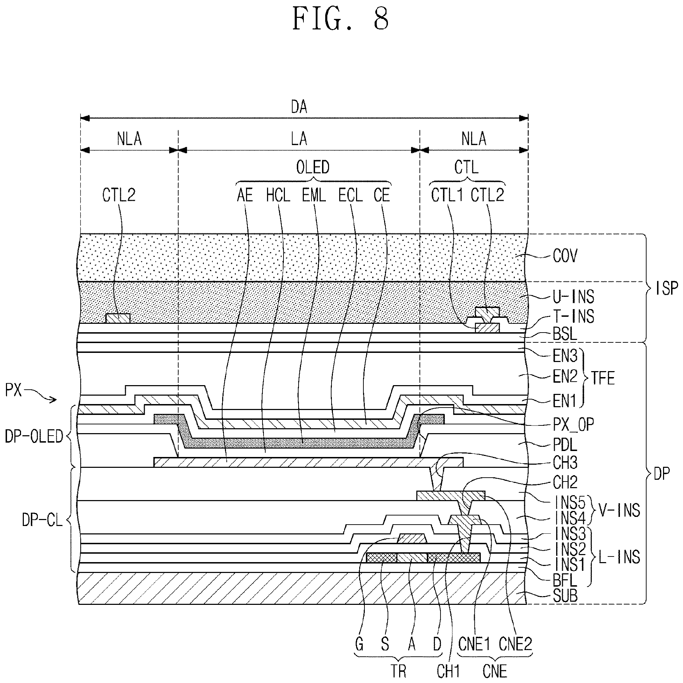

FIG. 8 illustrates a cross section of a display panel and an input sensing unit corresponding to any one pixel illustrated in FIG. 7 according to one or more embodiments of the present disclosure.

Referring to FIG. 8, a pixel PX may be arranged above (e.g., on) the substrate SUB. The pixel PX may include a transistor TR and a light-emitting element OLED. The light-emitting element OLED may include a first electrode AE (or anode), a second electrode CE (or cathode), a hole control layer HCL, an electron control layer ECL, and a light-emitting layer EML.

The transistor TR and the light-emitting element OLED may each be arranged on the substrate SUB. Although one transistor TR is illustrated as an example, substantially, the pixel PX may include a plurality of transistors and at least one capacitor for driving the light-emitting element OLED.

The display region DA may include a light-emitting region LA corresponding to each of the pixels PX and a non-light-emitting region NLA around (e.g., surrounding) the light-emitting region LA. The light-emitting element OLED may be arranged in the light-emitting region LA.

A buffer layer BFL may be arranged on the substrate SUB, and the buffer layer BFL may include an inorganic insulating layer. A semiconductor pattern may be arranged on the buffer layer BFL. The semiconductor pattern may include polysilicon, amorphous silicon, or a metal oxide.

The semiconductor pattern may be doped with an N-type (kind) dopant or a P-type (kind) dopant. The semiconductor pattern may include a highly doped region and a lightly doped region. The conductivity (e.g., electrical conductivity) of the highly doped region may be greater than that of the lightly doped region and substantially serve as a source electrode and a drain electrode of the transistor TR. The lightly doped region may substantially correspond to an active (or channel) of the transistor TR.

The source S, the active A, and the drain D of the transistor TR may be formed from the semiconductor pattern. A first insulating layer INS1 may be arranged on the semiconductor pattern. A gate G of the transistor TR may be arranged on the first insulating layer INS1. A second insulating layer INS2 may be arranged on the gate G. A third insulating layer INS3 may be arranged on the second insulating layer INS2.

A connection electrode CNE may include a first connection electrode CNE1 and a second connection electrode CNE2 for connecting the transistor TR and the light-emitting element OLED to each other. The first connection electrode CNE1 may be arranged on the third insulating layer INS3 and connected to the drain D through a first contact hole CH1 defined in the first to third insulating layers INS1 to INS3.

A fourth insulating layer INS4 may be arranged on the first connection electrode CNE1. The second connection electrode CNE2 may be arranged on the fourth insulating layer INS4. The second connection electrode CNE2 may be connected to the first connection electrode CNE1 through a second contact hole CH2 defined in the fourth insulating layer INS4.

A fifth insulating layer INS5 may be arranged on the second connection electrode CNE2. The layers from the buffer layer BFL to the fifth insulating layer INS5 may be defined as a circuit element layer DP-CL. The first to third insulating layers INS1 to INS3 may include inorganic insulating layers, and the fourth and fifth insulating layers INS4 and INS5 may include organic insulating layers.

The first electrode AE may be arranged on the fifth insulating layer INS5. The first electrode AE may be connected to the second connection electrode CNE2 through a third contact hole CH3 defined in the fifth insulating layer INS5. A pixel defining film PDL, in which an opening PX_OP for exposing a set or predetermined portion of the first electrode AE is defined, may be arranged on the first electrode AE and the fifth insulating layer INS5.

The hole control layer HCL may be arranged on the first electrode AE and the pixel defining film PDL. The hole control layer HCL may include a hole transport layer and a hole injection layer.

The light-emitting layer EML may be arranged on the hole control layer HCL. The light-emitting layer EML may be arranged in a region corresponding to the opening PX_OP. The light-emitting layer EML may include an organic material and/or an inorganic material. The light-emitting layer EML may generate any one selected from among red light, green light, and blue light.

The electron control layer ECL may be arranged on the light-emitting layer EML and the hole control layer HCL. The electron control layer ECL may include an electron transport layer and an electron injection layer. In one or more embodiments, the hole control layer HCL and the electron control layer ECL may be commonly arranged in the light-emitting region LA and the non-light-emitting region NLA.

The second electrode CE may be arranged on the electron control layer ECL. The second electrode CE may be commonly arranged in the pixels PX. The layers that constitute the light-emitting element OLED may be defined as a display element layer DP-OLED.

The buffer layer BFL and the first, second, and third insulating layers INS1, INS2, and INS3 arranged above (e.g., on) the substrate SUB may be defined as lower insulating layers L-INS. The transistor TR may be arranged between the lower insulating layers L-INS, and the light-emitting element OLED may be arranged above (e.g., on) the lower insulating layers L-INS and connected to the transistor TR. The fourth and fifth insulating layers INS4 and INS5 may be defined as via insulating layers V-INS.

The encapsulation layer TFE is arranged on the light-emitting element OLED. The encapsulation layer TFE may be arranged on the second electrode CE and cover the pixel PX. The encapsulation layer TFE may be defined as a thin film encapsulation layer.

The encapsulation layer TFE may include a plurality of insulating encapsulation layers EN1, EN2, and EN3. The insulating encapsulation layers EN1, EN2, and EN3 may include a first insulating encapsulation layer EN1 arranged on the second electrode CE, a second insulating encapsulation layer EN2 arranged on the first insulating encapsulation layer EN1, and a third insulating encapsulation layer EN3 arranged on the second insulating encapsulation layer EN2.

The first and third insulating encapsulation layers EN1 and EN3 may each include an inorganic insulating layer and protect the pixel PX from moisture/oxygen. The second insulating encapsulation layer EN2 may include an organic insulating layer and protect the pixel PX from foreign substances such as dust particles.

A first voltage may be applied to the first electrode AE through the transistor TR, and a second voltage having a lower level than the first voltage may be applied to the second electrode CE. Holes and electrons injected into the light-emitting layer EML may be combined to form excitons, and while the excitons transition and decay to a ground state, the light-emitting element OLED may be to emit light.

The input sensing unit ISP may be arranged on the encapsulation layer TFE. The input sensing unit ISP may be arranged directly on an upper surface of the encapsulation layer TFE. The input sensing unit ISP may include a base insulating layer BSL, a conductive pattern CTL, a touch insulating layer T-INS, an upper insulating layer U-INS, and a cover layer COV.

The base insulating layer BSL may be arranged on the third insulating encapsulation layer EN3. The base insulating layer BSL may include an inorganic insulating layer. At least one or more inorganic insulating layers may be provided as the base insulating layer BSL on the encapsulation layer TFE.

The conductive pattern CTL may be arranged on the base insulating layer BSL. The conductive pattern CTL may include a first conductive pattern CTL1 and a second conductive pattern CTL2 arranged on the first conductive pattern CTL1.

The first conductive pattern CTL1 may be arranged on the base insulating layer BSL. The touch insulating layer T-INS may be arranged on the first conductive pattern CTL1. The touch insulating layer T-INS may be arranged on the base insulating layer BSL to cover the first conductive pattern CTL1. The touch insulating layer T-INS may include an inorganic insulating layer.

The second conductive pattern CTL2 may be arranged on the touch insulating layer T-INS. The upper insulating layer U-INS may be arranged on the second conductive pattern CTL2. The upper insulating layer U-INS may be arranged on the touch insulating layer T-INS to cover the second conductive pattern CTL2. The upper insulating layer U-INS may include an organic insulating layer. The cover layer COV may be arranged on the upper insulating layer U-INS. The cover layer COV may include an organic insulating layer.

The first and second conductive patterns CTL1 and CTL2 may overlap the non-light-emitting region NLA. In one or more embodiments, the first and second conductive patterns CTL1 and CTL2 may be arranged on the non-light-emitting region NLA and each have a mesh shape.

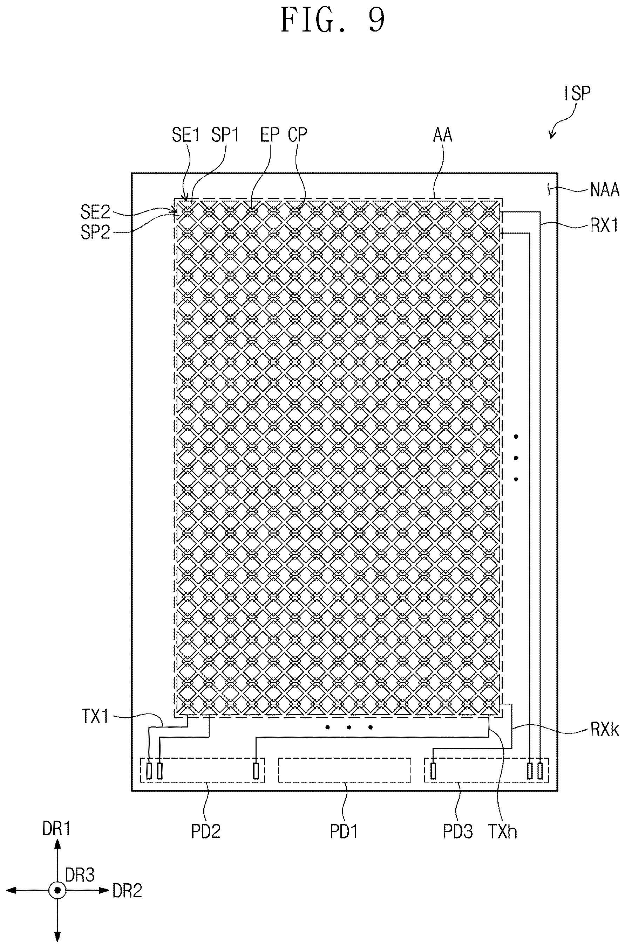

The first and second conductive patterns CTL1 and CTL2 may form the sensors of the input sensing unit ISP described above. For example, in one or more embodiments, the first and second conductive patterns CTL1 and CTL2 each having a mesh shape may be separated from each other in a set or predetermined region to form the sensors. A portion of the second conductive pattern CTL2 may be connected to the first conductive pattern CTL1. The configuration of the sensors formed by the first and second conductive patterns CTL1 and CTL2 will be described in more detail in FIGS. 9 to 11.

FIG. 9 is a plan view of the input sensing unit illustrated in FIG. 5 according to one or more embodiments of the present disclosure.

Referring to FIG. 9, the input sensing unit ISP may include a plurality of sensing electrodes SE1 and SE2, a plurality of lines TX1 to TXh and RX1 to RXk, a plurality of second pads PD2, and a plurality of third pads PD3. The sensing electrodes SE1 and SE2, the lines TX1 to TXh and RX1 to RXk, and the second and third pads PD2 and PD3 may be arranged on the encapsulation layer TFE.

The planar region of the input sensing unit ISP may include an active region AA and a non-active region NAA around the active region AA. The active region AA may overlap the display region DA, and the non-active region NAA may overlap the non-display region NDA.

The sensing electrodes SE1 and SE2 may be arranged in the active region AA, and the second and third pads PD2 and PD3 may be arranged in the non-active region NAA. When viewed on a plane (e.g., in plan view), the second pads PD2 and the third pads PD3 may be adjacent to a lower end of the input sensing unit ISP. When viewed on a plane (e.g., in plan view), the first pads PD1 may be arranged between the second pads PD2 and the third pads PD3. The description of the first pads PD1 may refer to the descriptions of FIG. 7.

The lines TX1 to TXh and RX1 to RXk may be each connected to one respective end of the sensing electrodes SE1 and SE2 and extend to the non-active region NAA to be connected to the second and third pads PD2 and PD3. In one or more embodiments, although not illustrated in FIG. 6, a sensing control unit, which controls the input sensing unit ISP, may be connected to the second and third pads PD2 and PD3 through a printed circuit board.

The sensing electrodes SE1 and SE2 may include a plurality of first sensing electrodes SE1 extending in the first direction DR1 and arranged in the second direction DR2 and a plurality of second sensing electrodes SE2 extending in the second direction DR2 and arranged in the first direction DR1. The second sensing electrodes SE2 may extend to be insulated from and cross the first sensing electrodes SE1.

The lines TX1 to TXh and RX1 to RXk may include a plurality of first lines TX1 to TXh connected to the first sensing electrodes SE1 and a plurality of second lines RX1 to RXk connected to the second sensing electrodes SE2, wherein h and k are each a natural number. The first lines TX1 to TXh may extend to the non-active region NAA to be connected to the second pads PD2. The second lines RX1 to RXk may extend to the non-active region NAA to be connected to the third pads PD3.

For example, when viewed on a plane (e.g., in plan view), the first lines TX1 to TXh may be arranged in the non-active region NAA adjacent to a lower side of the active region AA. When viewed on a plane (e.g., in plan view), the second lines RX1 to RXk may be arranged in the non-active region NAA adjacent to a right side of the active region AA. The first lines TX1 to TXh may be defined as transmission lines, and the second lines RX1 to RXk may be defined as sensing lines.

Each of the first sensing electrodes SE1 may include a plurality of first sensing units SP1 arranged in the first direction DR1 and a plurality of connection patterns CP connecting the first sensing units SP1 to each other. Each of the connection patterns CP may be arranged between two adjacent first sensing units SP1 in the first direction DR1 to connect the two first sensing units SP1 to each other.

Each of the second sensing electrodes SE2 may include a plurality of second sensing units SP2 arranged in the second direction DR2 and a plurality of extension patterns EP extending from the second sensing units SP2. Each of the extension patterns EP may be arranged between two adjacent second sensing units SP2 in the second direction DR2 and extend from the two second sensing units SP2.

The first sensing units SP1 and the second sensing units SP2 may be spaced and/or apart (e.g., spaced apart or separated) from each other without overlapping each other and may be arranged alternately. A capacitance may be formed by the first sensing units SP1 and the second sensing units SP2. The extension patterns EP may not overlap the connection patterns CP.

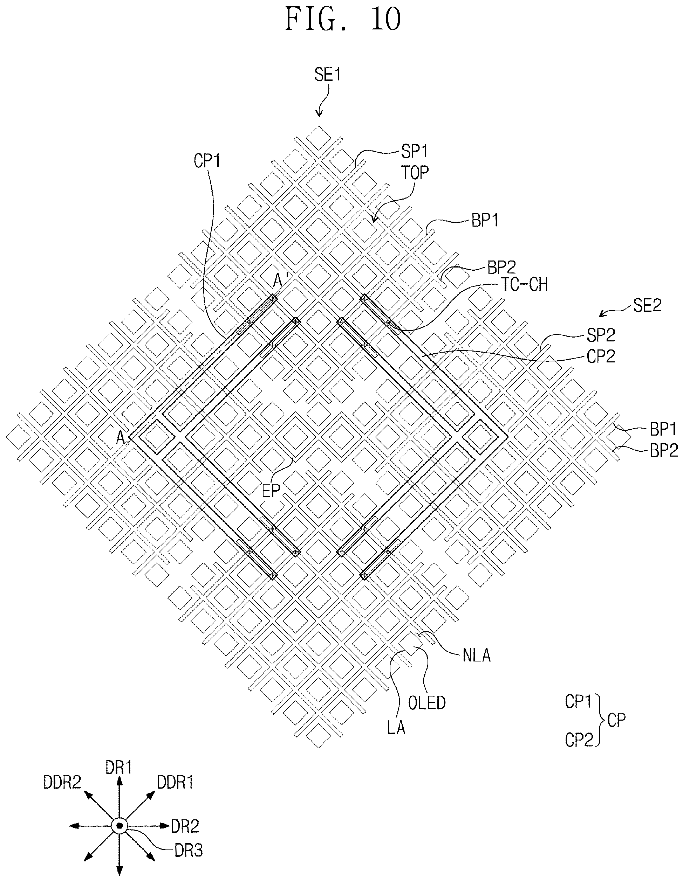

FIG. 10 is an enlarged view of two adjacent first sensing units and two adjacent second sensing units illustrated in FIG. 9 according to one or more embodiments of the present disclosure.

Referring to FIG. 10, the first sensing units SP1 and the second sensing units SP2 may each have a mesh shape. In order to have a mesh shape, each of the first and second sensing units SP1 and SP2 may include a plurality of first branch portions BP1 extending in a first diagonal direction DDR1 and a plurality of second branch portions BP2 extending in a second diagonal direction DDR2.

The first diagonal direction DDR1 may be defined as a direction crossing the first and second directions DR1 and DR2 on a plane defined by the first and second directions DR1 and DR2. The second diagonal direction DDR2 may be defined as a direction crossing the first diagonal direction DDR1 on the plane defined by the first and second directions DR1 and DR2. For example, the first direction DR1 and the second direction DR2 may cross each other normally (e.g., perpendicularly), and the first diagonal direction DDR1 and the second diagonal direction DDR2 may cross each other normally (e.g., perpendicularly).

The first branch portions BP1 of each of the first and second sensing units SP1 and SP2 may cross and be formed integrally with the second branch portions BP2 of each of the first and second sensing units SP1 and SP2. Touch openings TOP having a rhombus shape may be defined by the first branch portions BP1 and the second branch portions BP2.

When viewed on a plane (e.g., in plan view), the light-emitting regions LA may be correspondingly arranged within the touch openings TOP. The light-emitting elements OLED may be correspondingly arranged in the light-emitting regions LA. Each of the light-emitting regions LA may be the light-emitting region LA illustrated in FIG. 5. The first and second sensing units SP1 and SP2 may be arranged in the non-light-emitting region NLA. Because the first and second sensing units SP1 and SP2 are arranged in the non-light-emitting region NLA, light generated in the light-emitting regions LA may be normally emitted without being affected by the first and second sensing units SP1 and SP2.

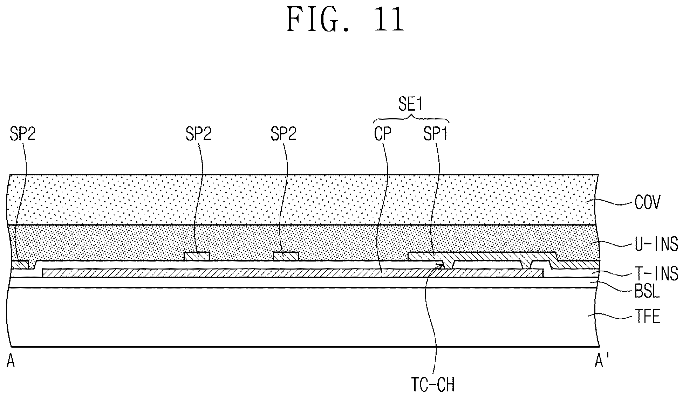

The connection pattern CP may extend so as not to overlap the extension pattern EP and connect the first sensing units SP1 to each other. The connection pattern CP may be connected to the first sensing units SP1 through a plurality of contact holes TC-CH. The structure of the contact holes TC-CH will be illustrated in FIG. 11. The connection pattern CP may extend toward the first sensing units SP1 via regions overlapping the second sensing units SP2.

The extension pattern EP may be arranged between the first sensing units SP1 and extend from the second sensing units SP2. The second sensing units SP2 and the extension pattern EP may be formed integrally. The extension pattern EP may have a mesh shape.

The extension pattern EP, the first sensing units SP1, and the second sensing units SP2 may be arranged at a same layer and may be formed by being concurrently (e.g., simultaneously) patterned using a same material. The connection pattern CP may be arranged in a layer different from that of the extension pattern EP, the first sensing units SP1, and the second sensing units SP2.

The connection pattern CP may include a first connection pattern CP1 and a second connection pattern CP2 having shapes that are symmetrical to each other in the second direction DR2. The extension pattern EP may be arranged between the first connection pattern CP1 and the second connection pattern CP2. In one or more embodiments, the first connection pattern CP1 and the second connection pattern CP2 may each have a bent shape.

The first connection pattern CP1 may extend toward the first sensing units SP1 via one of the two second sensing units SP2. The second connection pattern CP2 may extend toward the first sensing units SP1 via the other of the two second sensing units SP2.

The contact holes TC-CH may be defined to be adjacent to both (e.g., two) ends of the first connection pattern CP1 and both (e.g., two) ends of the second connection pattern CP2. When viewed on a plane (e.g., in plan view), the contact holes TC-CH may overlap the first sensing units SP1. The first connection pattern CP1 and the second connection pattern CP2 may be connected to the first sensing units SP1 through the contact holes TC-CH.

A bent portion of the first connection pattern CP1 and a bent portion of the second connection pattern CP2 may overlap the second sensing units SP2, respectively. A single touch opening TOP may be defined at each of the bent portion of the first connection pattern CP1 and the bent portion of the second connection pattern CP2. Each of the first connection pattern CP1 and the second connection pattern CP2 may include two mesh lines extending toward the first sensing units SP1.

FIG. 11 is a cross-sectional view taken along the line A-A' illustrated in FIG. 10 according to one or more embodiments of the present disclosure.

Referring to FIG. 10 and FIG. 11, the base insulating layer BSL may be arranged on the encapsulation layer TFE. The connection pattern CP may be arranged on the base insulating layer BSL. The touch insulating layer T-INS may be arranged on the connection pattern CP and the base insulating layer BSL. The touch insulating layer T-INS may be arranged on the base insulating layer BSL to cover the connection pattern CP. The connection pattern CP may be defined as the first conductive pattern CTL1 described above.

The first sensing unit SP1 and the second sensing unit SP2 may be arranged on the touch insulating layer T-INS. The extension pattern EP formed integrally with the second sensing unit SP2 may also be arranged on the touch insulating layer T-INS. The connection pattern CP may be connected to the first sensing unit SP1 through the plurality of contact holes TC-CH defined in the touch insulating layer T-INS.

The extension pattern EP, the first sensing unit SP1, and the second sensing unit SP2 may be arranged at a same layer on the touch insulating layer T-INS. The extension pattern EP, the first sensing unit SP1, and the second sensing unit SP2 may be defined as the second conductive pattern CTL2 described above. The connection pattern CP may be arranged below the extension pattern EP, the first sensing unit SP1, and the second sensing unit SP2.

The upper insulating layer U-INS may be arranged on the first and second sensing units SP1 and SP2 and the touch insulating layer T-INS, and the cover layer COV may be arranged on the upper insulating layer U-INS.

FIG. 12 is a cross-sectional view taken along the line I-I' illustrated in FIG. 7 according to one or more embodiments of the present disclosure.

Referring to FIG. 12, the lower insulating layers L-INS defined as the buffer layer BFL and the first to third insulating layers INS1 to INS3 may extend toward the non-display region NDA. The lower insulating layers L-INS may extend to an edge of the substrate SUB. Edges of the lower insulating layers L-INS may overlap the edge of the substrate SUB. The fourth and fifth insulating layers INS4 and INS5 and the pixel defining film PDL may extend up to a portion of the non-display region NDA adjacent to the display region DA.

The display panel DP may include a first dam DM1, a second dam DM2, and a third dam DM3 sequentially spaced and/or apart (e.g., spaced apart or separated) from the display region DA. In the non-display region NDA, the first dam DM1, the second dam DM2, and the third dam DM3 may be each arranged on the third insulating layer INS3.

The first dam DM1 may be arranged between the second dam DM2 and the display region DA. In the non-display region NDA, the first dam DM1 may be arranged between the second dam DM2 and the sides of the fourth and fifth insulating layers INS4 and INS5. The second dam DM2 may be arranged between the first dam DM1 and the third dam DM3. The third dam DM3 may be arranged between the second dam DM2 and the edge of the substrate SUB.

The second dam DM2 may be higher than the first dam DM1. The third dam DM3 may be lower than the first dam DM1. For example, in one or more embodiments, the first dam DM1 may be formed of three layers stacked on one another, the second dam DM2 may be formed of four layers stacked on one another, and the third dam DM3 may be formed of one layer.

The first dam DM1 may include layers formed of same materials as the fourth insulating layer INS4, the fifth insulating layer INS5, and the pixel defining film PDL. The second dam DM2 may include layers formed of the same materials as the fourth insulating layer INS4, the fifth insulating layer INS5, and the pixel defining film PDL. In addition, the second dam DM2 may further include a layer (for example, an organic layer) arranged higher than the pixel defining film PDL. The third dam DM3 may be formed of the same material as the fourth insulating layer INS4.

The lower insulating layers L-INS may be separated below the third dam DM3. The lower insulating layers L-INS may be separated to define a groove GV'. The third dam DM3 may fill the groove GV'.

If (e.g., when) a crack occurs at the edges of the lower insulating layers L-INS overlapping the edge of the substrate SUB, the crack may propagate into the display panel DP. The groove GV' may prevent or reduce such a crack from propagating into the display region DA of the display panel DP.

The hole control layer HCL, the electron control layer ECL, and the second electrode CE may extend to the non-display region NDA adjacent to the display region DA and be arranged on the fifth insulating layer INS5.

The first insulating encapsulation layer EN1 may extend to the non-display region NDA. In the non-display region NDA, the first insulating encapsulation layer EN1 may be arranged on the third insulating layer INS3 so as to cover the first dam DM1, the second dam DM2, and the third dam DM3.

The second insulating encapsulation layer EN2 may extend to the non-display region NDA. The second insulating encapsulation layer EN2 may be arranged up to the first dam DM1. When the display device DD is manufactured, a fluidic organic material may be cured to form the second insulating encapsulation layer EN2. The fluidic organic material may flow into the non-display region NDA, but it can be blocked by the first dam DM1. In one or more embodiments, the organic material overflowing the first dam DM1 may be further blocked by the second dam DM2.

The third insulating encapsulation layer EN3 may extend to the non-display region NDA. The third insulating encapsulation layer EN3 may be arranged on the first insulating encapsulation layer EN1 and the second insulating encapsulation layer EN2 in the non-display region NDA.

In one or more embodiments, the encapsulation layer TFE may extend to the edge of the substrate SUB. For example, the first insulating encapsulation layer EN1 and the third insulating encapsulation layer EN3 may extend to the edge of the substrate SUB. The edges of the first and third insulating encapsulation layers EN1 and EN3 may overlap the edge of the substrate SUB.

The base insulating layer BSL may extend to the non-display region NDA and be arranged on the third insulating encapsulation layer EN3. The touch insulating layer T-INS may extend to the non-display region NDA and be arranged on the base insulating layer BSL. The base insulating layer BSL and the touch insulating layer T-INS may be spaced and/or apart (e.g., spaced apart or separated) from the edge of the substrate SUB. For example, an edge of each of the base insulating layer BSL and the touch insulating layer T-INS may be spaced from the edge of the substrate SUB.

The upper insulating layer U-INS may extend to the non-display region NDA and be arranged on the touch insulating layer T-INS. An edge of the upper insulating layer U-INS may be spaced and/or apart (e.g., spaced apart or separated) from the edge of the substrate SUB. A distance DT between the edge of the upper insulating layer U-INS and the edge of the substrate SUB may be about 20 micrometers (µm) to about 200 µm, for example, about 40 µm to about 120 µm. A thickness of the upper insulating layer U-INS may be about 0.1 µm to about 10 µm, for example, about 2 µm to about 4 µm.

When viewed on a plane (e.g., in plan view), the base insulating layer BSL may overlap the upper insulating layer U-INS, and the edge of the base insulating layer BSL may overlap the edge of the upper insulating layer U-INS. When viewed on a plane (e.g., in plan view), the touch insulating layer T-INS may overlap the upper insulating layer U-INS, and the edge of the touch insulating layer T-INS may overlap the edge of the upper insulating layer U-INS.

The cover layer COV may extend to the non-display region NDA and be arranged on the upper insulating layer U-INS. The cover layer COV may extend to the edge of the substrate SUB and be arranged on the third insulating encapsulation layer EN3 so as to cover the upper insulating layer U-INS. An edge of the cover layer COV may overlap the edge of the substrate SUB.

A second adhesive layer AL2 may be arranged on the cover layer COV. A reflection prevention layer RPL may be arranged on the second adhesive layer AL2, and the reflection prevention layer RPL may be attached to the cover layer COV by the second adhesive layer AL2. The second adhesive layer AL2 may extend to the edge of the substrate SUB, and an edge of the second adhesive layer AL2 may overlap the edge of the substrate SUB.

The step portion STP may be defined by an edge of the display panel DP and the edge of the upper insulating layer U-INS. The edge of the display panel DP may be defined by the edge of the substrate SUB, the edges of the lower insulating layers L-INS, and the edges of the first and third insulating encapsulation layers EN1 and EN3.

Because the edge of the display panel DP (e.g., the third side S3) and the edge of the upper insulating layer U-INS (e.g., the third side S3', see FIG. 7) are arranged at different heights, the step portion STP may be defined. Substantially, the edge of the display panel DP defining the step portion STP may be the first side S1, the third side S3, and the fourth side S4 illustrated in FIG. 7 described above. In addition, the edge of the upper insulating layer U-INS defining the step portion STP may be the first side S1', the third side S3', and the fourth side S4' illustrated in FIG. 7 described above.

In one or more embodiments of the present disclosure, at least one insulating layer selected from among the lower insulating layers BFL and INS1 to INS3, the insulating encapsulation layers EN1 and EN3, and the base insulating layer BSL may extend to the edge of the substrate SUB. In addition, a first surface roughness of a first upper surface of the at least one insulating layer exposed upward by the upper insulating layer U-INS is greater than a second surface roughness of a second upper surface of the at least one insulating layer covered by the upper insulating layer U-INS.

FIG. 12 is an example embodiment of the present disclosure, and the at least one insulating layer selected from among the aforementioned insulating layers may be the third insulating encapsulation layer EN3 in FIG. 12. For example, an upper surface of the third insulating encapsulation layer EN3 may include a first upper surface US1, which is exposed upward without being covered by the upper insulating layer U-INS, and a second upper surface US2 covered by the upper insulating layer U-INS. In other words, the uppermost insulating layer of the insulating encapsulation layers EN1, EN2, and EN3 (for example, the third insulating encapsulation layer EN3) may include the first upper surface US1 and the second upper surface US2.

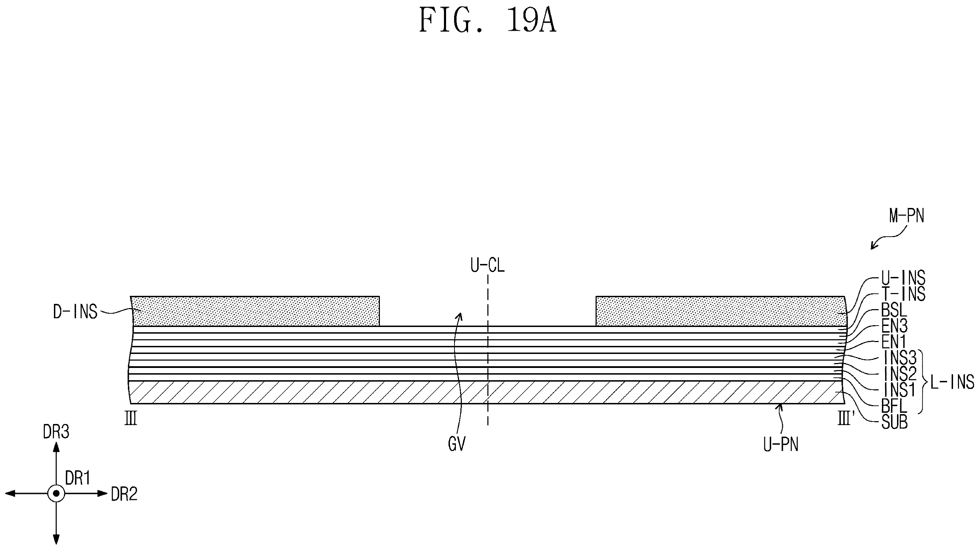

The first surface roughness of the first upper surface US1 is greater than the second surface roughness of the second upper surface US2. The first upper surface US1 may be surface-treated through a dry etching process to have a high surface roughness. In a region that does not overlap the upper insulating layer U-INS, the touch insulating layer T-INS and the base insulating layer BSL may be removed by a dry etching process, and the dry etching process may be performed on the first upper surface US1 of the third insulating encapsulation layer EN3. The dry etching process for the first upper surface US1 will be described in more detail with reference to FIGS. 19A to 19D.

The cover layer COV may be in contact with the first upper surface US1 of the third insulating encapsulation layer EN3. As the surface roughness increases, the adhesive force between the cover layer COV and the first upper surface US1 may improve (e.g., increase). In one or more embodiments of the present disclosure, as the surface roughness of the first upper surface US1, which is exposed without being covered by the upper insulating layer U-INS, increases, the adhesive force of the cover layer COV to the first upper surface US1 may improve and increase. Because the cover layer COV is more firmly attached to the third insulating encapsulation layer EN3, the cover layer COV and the third insulating encapsulation layer EN3 may not be separated from each other by an external impact.

In one or more embodiments of the present disclosure, a difference between the first surface roughness of the first upper surface US1 and the second surface roughness of the second upper surface US2 may be about 10 nm to about 70 nm. The first surface roughness may be about 30 nm to about 70 nm, and the second surface roughness may be about 1 nm to about 20 nm. For example, in one or more embodiments, the first surface roughness may be about 66.1 nm, and the second surface roughness may be about 1.3 nm. In the present disclosure, the term "surface roughness" refers to an average distance between the highest peak and lowest valley in each sampling length of the surface profile of a surface of a layer.

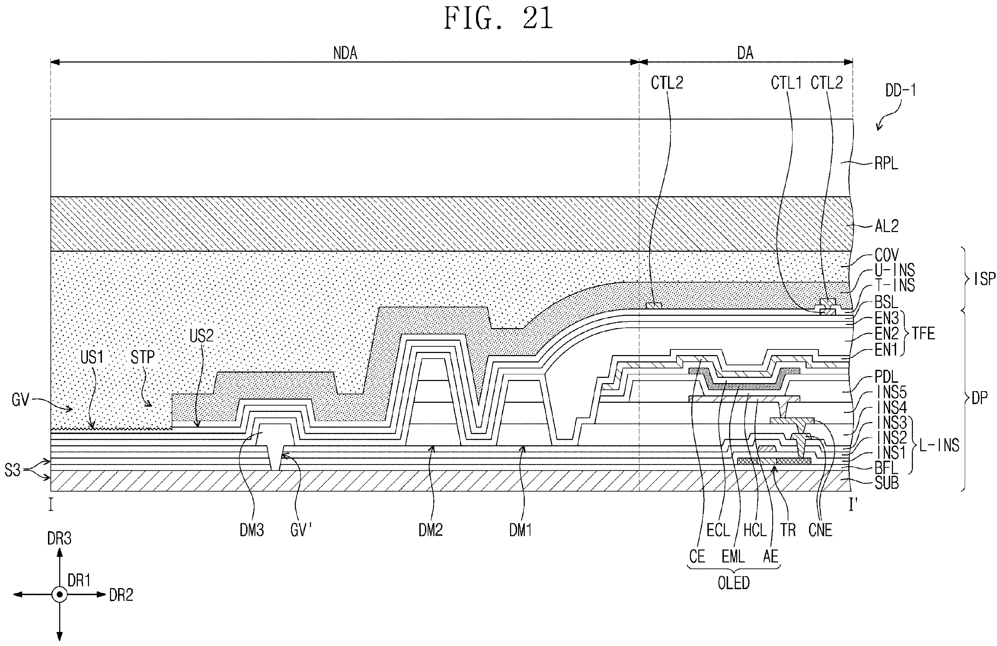

In FIG. 12, the at least one insulating layer is described as the third insulating encapsulation layer EN3, but embodiments of the present disclosure are not limited thereto, in one or more embodiments, the at least one insulating layer may be the base insulating layer. In one or more embodiments, the at least one insulating layer may be the first insulating encapsulation layer EN1. In one or more embodiments, the at least one insulating layer may be any one selected from among the lower insulating layers L-INS. These embodiments will be described in more detail with reference to FIGS. 21 to 24.

The sum of the thicknesses of the lower insulating layers L-INS and the first and third insulating encapsulation layers EN1 and EN3 in a region not overlapping the upper insulating layer U-INS may be about 0 angstroms (Å) to about 26,000 Å, for example, about 0 Å to about 1,000 Å.

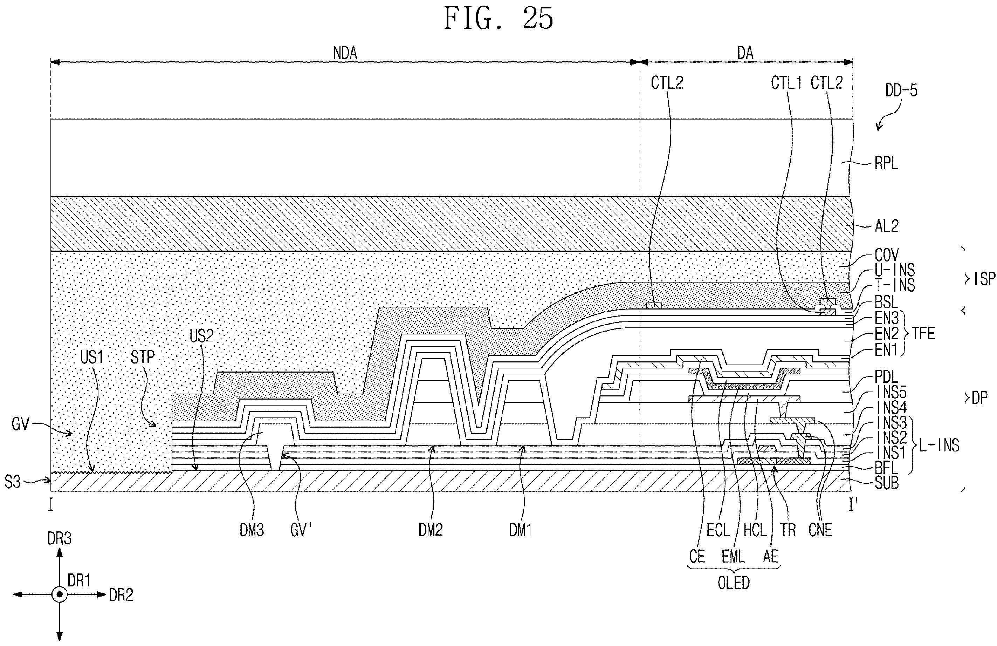

In the region not overlapping the upper insulating layer U-INS, as the number of insulating layers removed among the lower insulating layers L-INS and the first and third insulating encapsulation layers EN1 and EN3 increases, the sum of the thicknesses of the insulating layers may decrease. If (e.g., when) all of the lower insulating layers L-INS and the first and third insulating encapsulation layers EN1 and EN3 are removed in the region not overlapping the upper insulating layer U-INS, the sum of the thicknesses of the insulating layers may be zero, and the structure thereof may be substantially as illustrated in FIG. 25.

FIG. 13 is a cross-sectional view taken along the line II-II' illustrated in FIG. 7 according to one or more embodiments of the present disclosure.

Referring to FIG. 13, the upper insulating layer U-INS and the dummy insulating layer D-INS may be arranged at a same layer. For example, the upper insulating layer U-INS and the dummy insulating layer D-INS may be arranged on the touch insulating layer T-INS. Substantially, the upper insulating layer U-INS and the dummy insulating layer D-INS may be formed concurrently (e.g., simultaneously) from a same material. A groove GV may be defined between the upper insulating layer U-INS and the dummy insulating layer D-INS.

The base insulating layer BSL and the touch insulating layer T-INS may overlap the upper insulating layer U-INS and the dummy insulating layer D-INS. The base insulating layer BSL and the touch insulating layer T-INS may not be arranged in the groove GV. A third surface roughness of a third upper surface US3 of the third insulating encapsulation layer EN3 (the at least one insulating layer described above) exposed by the groove GV may be substantially the same as the first surface roughness described above and greater than the second surface roughness described above.

The cover layer COV may be arranged on the upper insulating layer U-INS and the dummy insulating layer D-INS and fills the groove GV. The cover layer COV may be in contact with the third upper surface US3 in the groove GV. The cover layer COV may be more firmly attached to the third upper surface US3 having a high surface roughness. The cover layer COV may be arranged on a portion of the dummy insulating layer D-INS. The second adhesive layer AL2 and the reflection prevention layer RPL may be arranged on a flat surface of the cover layer COV.

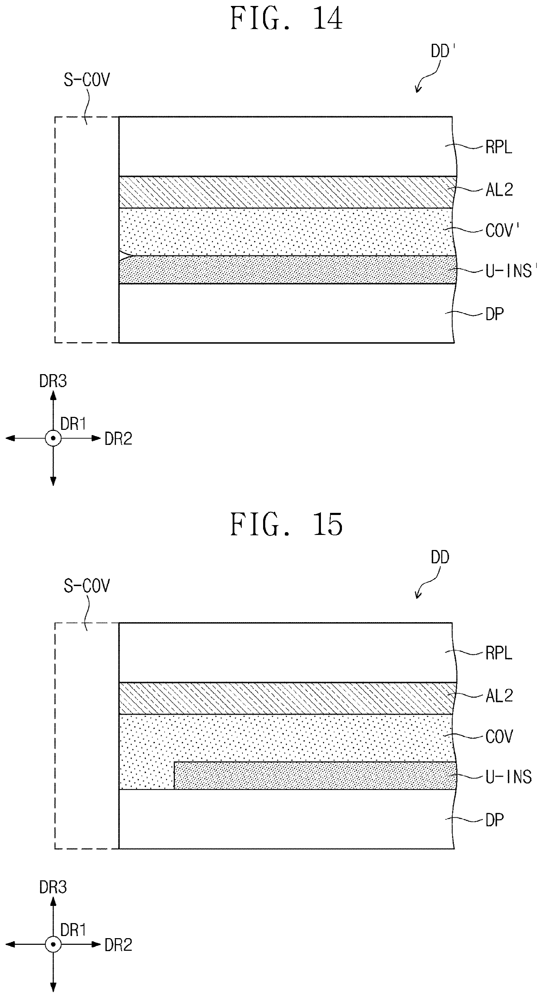

FIG. 14 illustrates a cross-sectional configuration of a comparative display device DD' according to the present disclosure.

For the convenience of explanation, in FIG. 14, the detailed configuration of the display panel DP is omitted, the display panel DP is illustrated as a single layer, and the conductive pattern CTL, the base insulating layer BSL, and the touch insulating layer T-INS are also omitted.

Referring to FIG. 14, a side cover layer S-COV may be arranged on an edge of an upper insulating layer U-INS' and an edge of a cover layer COV'. The edge of the upper insulating layer U-INS' and the edge of the cover layer COV' of the comparative display device DD' may overlap an edge of the display panel DP. If (e.g., when) the side cover layer S-COV is not arranged, the edge of the upper insulating layer U-INS' and the edge of the cover layer COV' may be exposed to the outside.

An external impact may be applied to the side cover layer S-COV. The side cover layer S-COV may be to absorb the external impact, but if (e.g., when) the external impact is large, the amount of impact transmitted to the edge of the upper insulating layer U-INS' and the edge of the cover layer COV' may increase.

When the amount of impact transmitted to the edge of the upper insulating layer U-INS' and the edge of the cover layer COV' is large enough to damage the upper insulating layer U-INS' and the cover layer COV', the edge of the upper insulating layer U-INS' and the edge of the cover layer COV' may be peeled off. Accordingly, the side portion of the comparative display device DD' may be damaged.

FIG. 15 schematically illustrates a configuration of the display device DD illustrated in FIG. 12 according to one or more embodiments of the present disclosure.

For example, FIG. 15 is illustrated as a cross-sectional view corresponding to FIG. 14. Therefore, in FIG. 15, similar to FIG. 14, the detailed configuration of the display panel DP is omitted, the display panel DP is illustrated as a single layer, and in addition, the base insulating layer BSL and the touch insulating layer T-INS are omitted.

Referring to FIG. 15, a side cover layer S-COV may be arranged on the edge of the upper insulating layer U-INS and the edge of the cover layer COV. The edge of the upper insulating layer U-INS may be spaced and/or apart (e.g., spaced apart or separated) from the edge of the display panel DP, and the cover layer COV may be arranged on the display panel DP so as to cover the edge of the upper insulating layer U-INS. The edge of the cover layer COV and the edge of the second adhesive layer AL2 may overlap the edge of the display panel DP. Because an external impact may be absorbed by the side cover layer S-COV and the cover layer COV, the amount of impact transmitted to the upper insulating layer U-INS may be reduced.

In this case, a phenomenon, in which the edge of the upper insulating layer U-INS' and the edge of the cover layer COV' illustrated in FIG. 14 are peeled off, may not occur in the display device DD illustrated in FIG. 15.

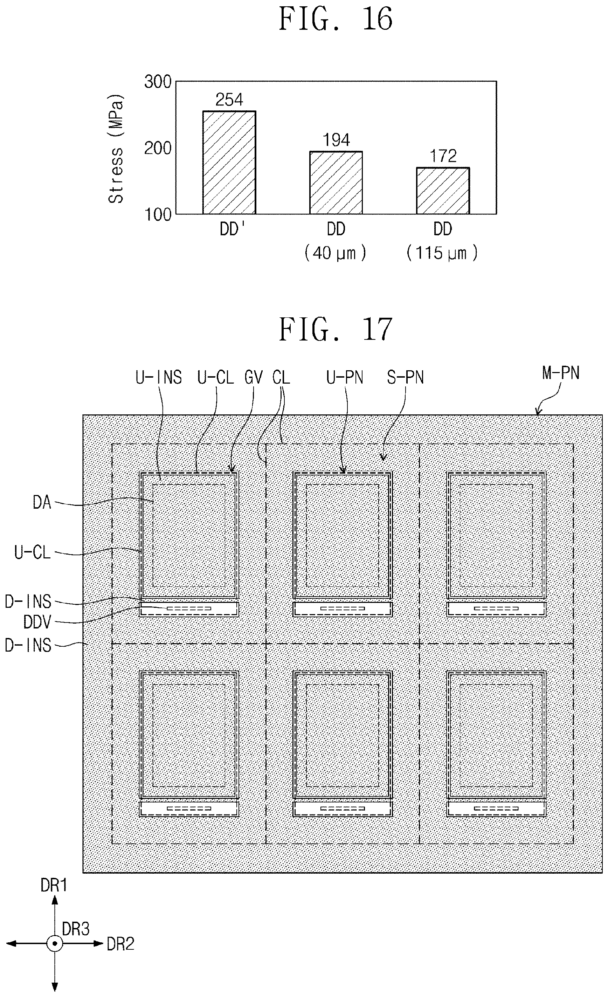

FIG. 16 illustrates the external impact test results for the comparative display device illustrated in FIG. 14 and the display device illustrated in FIG. 15 according to the present disclosure.

In FIG. 16, the vertical axis represents stress, and the stress may be measured in megapascals (MPa). The stress may substantially correspond to the amount of impact transmitted to the upper insulating layer U-INS. In addition, in FIG. 16, the numerical values shown for the display device DD may represent the distances between the edge of the substrate SUB and the edge of the upper insulating layer U-INS.

Referring to FIG. 16, the amount of impact transmitted to the upper insulating layer U-INS in the display device DD may be reduced compared to the amount of impact transmitted to the upper insulating layer U-INS' in the comparative display device DD'. In addition, in FIG. 16, as the distance between the edge of the substrate SUB and the edge of the upper insulating layer U-INS increases, that is, as the edge of the upper insulating layer U-INS is spaced further apart from the edge of the substrate SUB, the amount of impact transmitted to the upper insulating layer U-INS may be reduced.

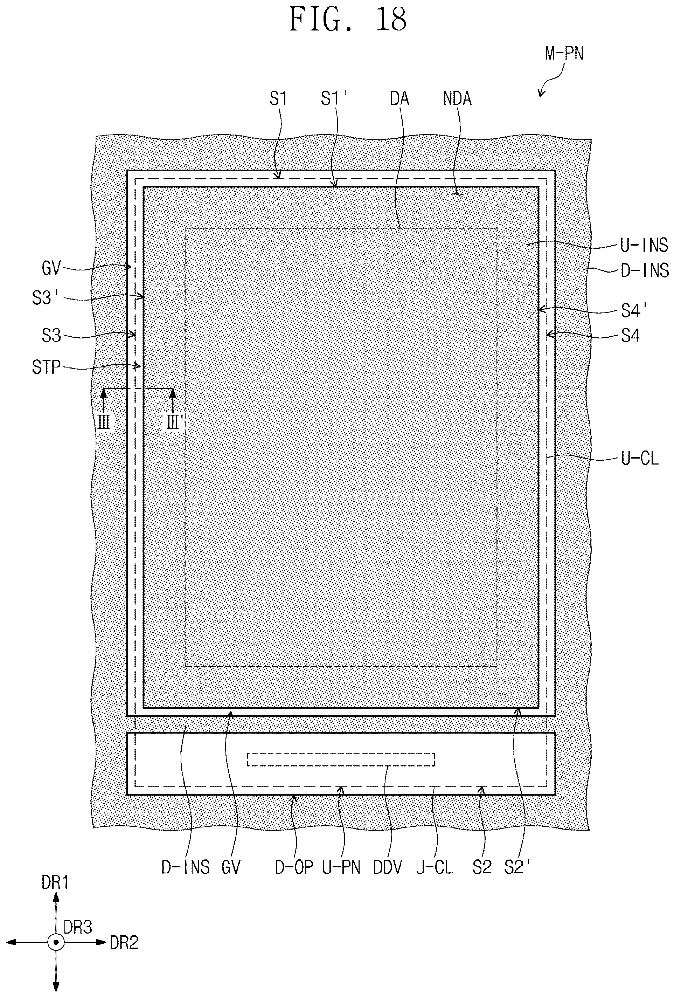

FIG. 17 illustrates a planar configuration of a mother panel including the display panel illustrated in FIG. 7 according to one or more embodiments of the present disclosure. FIG. 18 is an enlarged view of any one unit panel illustrated in FIG. 17.

Referring to FIG. 17, a mother panel M-PN may include a plurality of unit panels U-PN arranged in the first direction DR1 and the second direction DR2. Each of the unit panels U-PN may be the display panel DP illustrated in FIG. 7. For example, in FIG. 17, the display region DA and the data driver DDV are each illustrated in dotted lines.

A cutting line CL and a unit cutting line U-CL may be defined in the mother panel M-PN. For example, the cutting line CL and the unit cutting line U-CL are illustrated in dotted lines. The edge of each of the unit panels U-PN may be defined as the unit cutting line U-CL.

A region defined by the cutting line CL may be larger than a region defined by the unit cutting line U-CL. The cutting line CL may be defined further outward than the unit cutting line U-CL and divide the mother panel M-PN into sub-panels S-PN corresponding to the unit panels U-PN. The areas of the sub-panels S-PN may be larger than the areas of the unit panels U-PN.

Along the cutting line CL, the mother panel M-PN may be first cut so that the mother panel M-PN may be separated into a plurality of sub-panels S-PN. Hereafter, along the unit cutting line U-CL, portions of the sub-panels S-PN may be cut to form unit panels U-PN. The unit cutting line U-CL may correspond to the first to fourth sides S1 to S4 of the display panel DP described above.

After the input sensing units ISP and the reflection prevention layers RPL described above are arranged on the unit panels U-PN, the unit panels U-PN may be separated from the mother panel M-PN. When the unit panels U-PN are separated, the input sensing units ISP may also be separated from each other, and the reflection prevention layers RPL may also be separated from each other.

The upper insulating layer U-INS and the dummy insulating layer D-INS described above may be arranged on each of the unit panels U-PN. A groove GV may be defined between the upper insulating layer U-INS and the dummy insulating layer D-INS.

Referring to FIG. 18, a groove GV may be defined on the unit panel U-PN, and the groove GV may correspond to the step portion STP and the groove GV illustrated in FIGS. 7, 12, and 13. The groove GV defined between a portion (for example, the second side S2') of the groove GV and the dummy insulating layer D-INS illustrated in FIG. 18 may remain on the display panel DP so that the groove GV illustrated in FIG. 7 may be defined.

Therefore, the grooves GV illustrated in FIGS. 17 and 18 are illustrated using the same reference characters as the groove GV illustrated in FIG. 7. For example, in order to more clearly illustrate and explain the shape of the groove GV in FIG. 18, the groove GV in FIG. 18 is illustrated to be relatively larger than the groove GV illustrated in FIG. 7.

The dummy insulating layer D-INS may be arranged around the upper insulating layer U-INS so as to be around (e.g., surround) the upper insulating layer U-INS. The groove GV may be defined between the upper insulating layer U-INS and the dummy insulating layer D-INS. The groove GV may be defined as a tetragonal closedloop shape corresponding to the shape of the upper insulating layer U-INS.

The groove GV may overlap a portion of the unit cutting line U-CL. For example, the groove GV may overlap the unit cutting line U-CL adjacent to each of the first side S1', the third side S3', and the fourth side S4'.

The groove GV overlapping the unit cutting line U-CL adjacent to the first side S1' may extend in the second direction DR2. The groove GV overlapping the unit cutting line U-CL adjacent to each of the third side S3' and the fourth side S4' may extend in the first direction DR1. The groove GV spaced and/or apart (e.g., spaced apart or separated) from the second side S2 and defined between the second side S2' and the dummy insulating layer D-INS may extend in the second direction DR2.

A width of the groove GV overlapping the unit cutting line U-CL adjacent to each of the first side S1', the side S3', and the fourth side S4' may be greater than a width of the groove GV defined between the second side S2' and the dummy insulating layer D-INS. In this disclosure, the term 'width' may be defined as a numerical value measured in a direction crossing the extension direction of the component.

When the unit panel U-PN is cut and separated along the unit cutting line U-CL, the step portion STP described above may be formed at a portion cut along the unit cutting line U-CL adjacent to the first side S1', the third side S3', and the fourth side S4'. When the unit panel U-PN is cut and separated along the unit cutting line U-CL, the groove GV defined between the second side S2' and the dummy insulating layer D-INS may remain on the unit panel U-PN.

An opening D-OP may be defined in the dummy insulating layer D-INS. The opening D-OP may be defined to expose the data driver DDV. The opening D-OP may expose a portion of the unit panel U-PN adjacent to the data driver DDV. The groove GV may be defined between the opening D-OP and the display region DA.

FIGS. 19A to 19D are cross-sectional views taken along the line III-III' illustrated in FIG. 18 and explain a method for manufacturing a display device according to one or more embodiments of the present disclosure.

For example, in FIGS. 19A to 19D, the insulating layers BFL, INS1 to INS3, EN1, EN3, BSL, T-INS, and U-INS arranged in the non-display region are illustrated, and the dams DM1, DM2, and DM3 are omitted for not obscuring the drawings.

Referring to FIG. 19A, the lower insulating layers L-INS, the base insulating layer BSL, and the touch insulating layer T-INS may be provided above (e.g., on) the substrate SUB. The lower insulating layers L-INS, the base insulating layer BSL, and the touch insulating layer T-INS may extend up to the unit cutting line U-CL defining the edge of the substrate SUB.

The first conductive pattern CTL1 and the second conductive pattern CTL2 illustrated in FIG. 12 may be arranged on the unit panel U-PN, and the upper insulating layer U-INS may be arranged on the second conductive pattern CTL2. A portion of the upper insulating layer U-INS overlapping the unit cutting line U-CL may be removed to define a groove GV. A portion of the touch insulating layer T-INS overlapping the unit cutting line U-CL may be exposed upward by the groove GV.

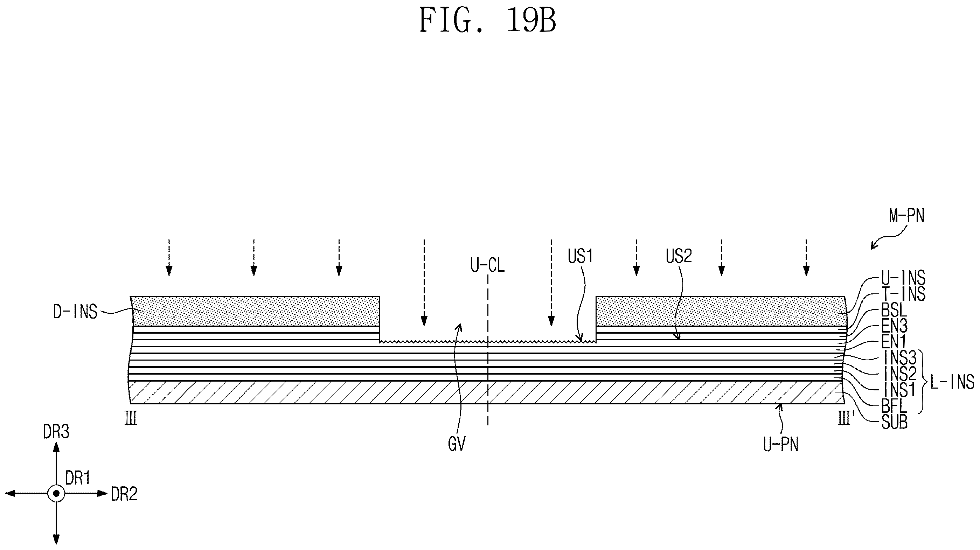

Referring to FIG. 19A and FIG. 19B, a dry etching process may be performed on the mother panel M-PN using the upper insulating layer U-INS as a mask. For example, in one or more embodiments, ions generated from plasma may be accelerated by an electric field and collide with a material to be etched, thereby performing the dry etching process.

Through the dry etching process, a portion of the touch insulating layer T-INS and a portion of the base insulating layer BSL, which are exposed by the groove GV, may be removed. As the portion of the touch insulating layer T-INS and the portion of the base insulating layer BSL are removed, a portion of the third insulating encapsulation layer EN3 overlapping the groove GV may be exposed upward. An upper surface of the portion of the third insulating encapsulation layer EN3 overlapping the groove GV may have a high surface roughness through the dry etching process.

When the dry etching process is performed, ions generated from plasma are accelerated by an electric field and collide with a material to be etched, so that the material may be etched. After the portion of the touch insulating layer T-INS and the portion of the base insulating layer BSL are removed, ion particles may collide with the upper surface of a portion of the third insulating encapsulation layer EN3 overlapping the groove GV. The dry etching process may be performed so that the portion of the third insulating encapsulation layer EN3 overlapping the groove GV is not completely removed.

In this regard, as the upper surface of the third insulating encapsulation layer EN3 overlapping the groove GV is etched, the surface of the upper surface of the third insulating encapsulation layer EN3 overlapping the groove GV may become rough. According to the above process, the third insulating encapsulation layer EN3 may include a first upper surface US1 exposed by the groove GV and having a first surface roughness and a second upper surface US2 covered by the upper insulating layer U-INS and having a second surface roughness. For example, the first upper surface US1 may be surface-treated by the dry etching process to have a high surface roughness.

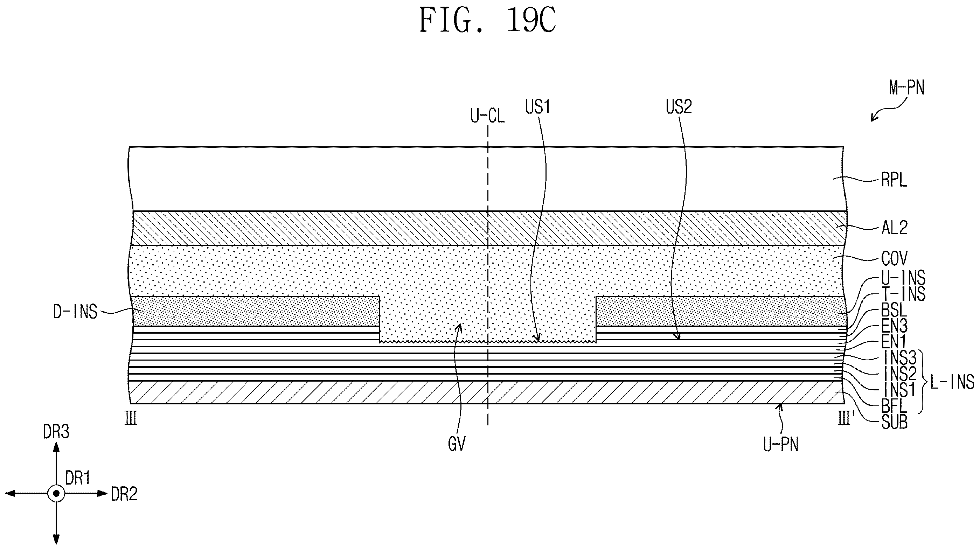

Referring to FIG. 19C, in one or more embodiments, an organic ink having fluidity may be provided on the upper insulating layer U-INS, and the organic ink may be cured to form a cover layer COV. The cover layer COV may fill the groove GV. A second adhesive layer AL2 may be arranged on the cover layer COV, and a reflection prevention layer RPL may be arranged on the second adhesive layer AL2.

Because the cover layer COV fills the groove GV, the cover layer COV may be in contact with the first upper surface US1. Due to the dry etching process, the surface roughness of the first upper surface US1 increases, so that the adhesive force between the cover layer COV and the first upper surface US1 may improve and increase. Accordingly, because the cover layer COV is more firmly attached to the third insulating encapsulation layer EN3, the cover layer COV and the third insulating encapsulation layer EN3 may not be separated from each other by an external impact.

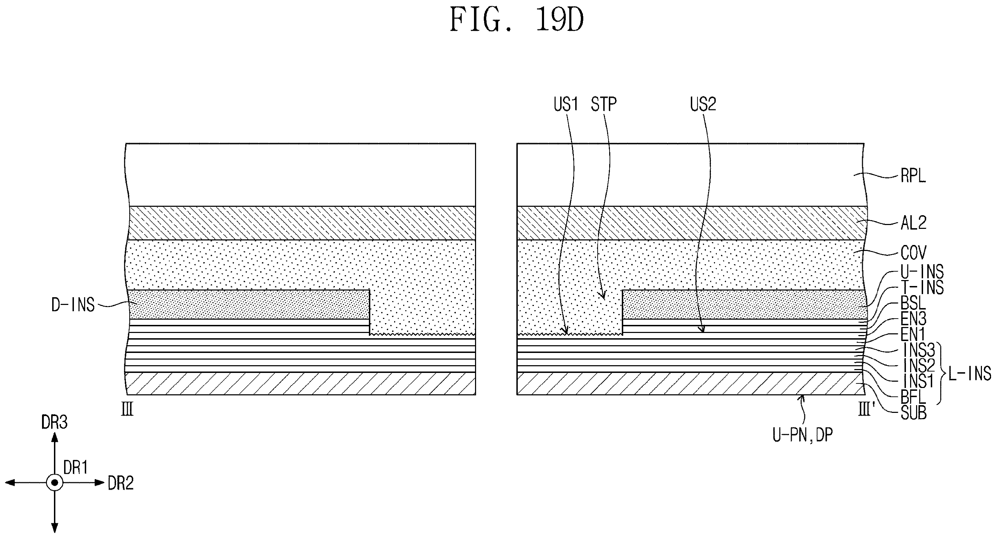

Referring to FIG. 19D, after cutting, the unit panel U-PN may be separated by the unit cutting line U-CL to form a display panel DP. In addition, a step portion STP may be defined.

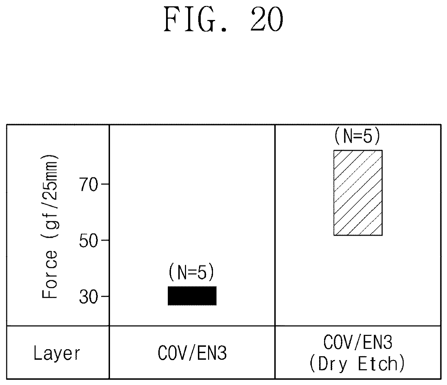

FIG. 20 illustrates test results regarding the adhesive force between the third insulating encapsulation layer and the cover layer according to one or more embodiments of the present disclosure.

Referring to FIG. 20, tests were performed on five samples (N=5), and regions in which the adhesive forces of the five samples were distributed are illustrated as bar graphs. The left test result shows an adhesive force between the cover layer COV and the third insulating encapsulation layer EN3 on which a dry etching process was not performed. The right test result shows an adhesive force between the cover layer COV and the third insulating encapsulation layer EN3 on which a dry etching process was performed.

The adhesive force between the cover layer COV and the third insulating encapsulation layer EN3 on which a dry etching process was performed may be greater than the adhesive force between the cover layer COV and the third insulating encapsulation layer EN3 on which a dry etching process was not performed. Accordingly, for the samples with the dry-etched third insulating encapsulation layer EN3, the cover layer COV may be more firmly attached to the first upper surface US1 of the third insulating encapsulation layer EN3 as described above.

FIGS. 21 to 25 illustrate portions of insulating layers each having a first upper surface formed thereon according to embodiments of the present disclosure.

FIGS. 21 to 25 are illustrated in cross sections corresponding to FIG. 12 according to one or more embodiments of the present disclosure, and the components illustrated in FIGS. 21 to 25 will be described in more detail, with a focus on components different from those illustrated in FIG. 12.

Referring to FIGS. 21 to 24, as described above, a first surface roughness of a first upper surface of at least one insulating layer, which is exposed upward without being covered by the upper insulating layer U-INS, may be greater than a second surface roughness of a second upper surface of at least one insulating layer covered by the upper insulating layer U-INS.

Referring to FIG. 21, as described in FIG. 19A, the lower insulating layers L-INS, the first and third insulating encapsulation layers EN1 and EN3, the base insulating layer BSL, and the touch insulating layer T-INS may extend up to the unit cutting line U-CL. Hereafter, through the dry etching process described in FIG. 19B, a portion of the touch insulating layer T-INS exposed by the groove GV is removed, and then, an upper surface of the base insulating layer BSL exposed by the groove GV may be surface-treated by the dry etching process to have a high surface roughness.

In a display device DD-1, the base insulating layer BSL, the first and third insulating encapsulation layers EN1 and EN3, and the lower insulating layers L-INS may extend to the edge of the substrate SUB. In addition, the base insulating layer BSL may include a first upper surface US1, which is not covered by the upper insulating layer U-INS and has a first surface roughness, and a second upper surface US2 which is covered by the upper insulating layer U-INS and has a second surface roughness. The first surface roughness is greater than the second surface roughness. The cover layer COV may be in contact with the first upper surface US1 of the base insulating layer BSL.

The touch insulating layer T-INS may be spaced and/or apart (e.g., spaced apart or separated) from the edge of the substrate SUB and overlap the upper insulating layer U-INS. The edge of the touch insulating layer T-INS may overlap the edge of the upper insulating layer U-INS.

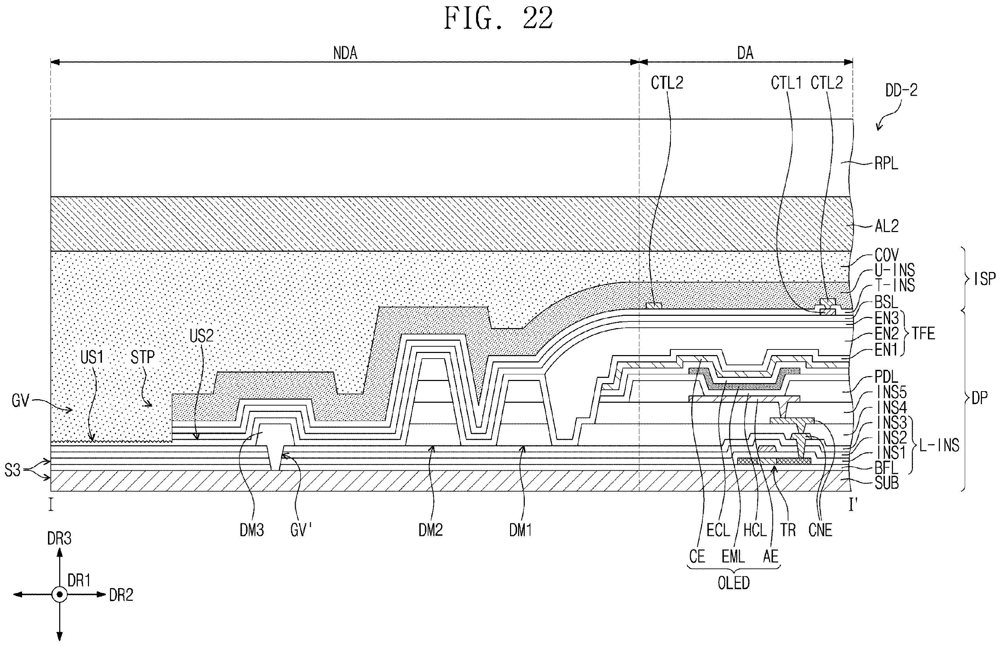

Referring to FIG. 22, as described in FIG. 19A, the lower insulating layers L-INS, the first and third insulating encapsulation layers EN1 and EN3, the base insulating layer BSL, and the touch insulating layer T-INS may extend up to the unit cutting line U-CL. Hereafter, through the dry etching process described in FIG. 19B, a portion of the touch insulating layer T-INS, a portion of the base insulating layer BSL, and a portion of the third insulating encapsulation layer EN3, which are exposed by the groove GV, are removed, and then, an upper surface of the first insulating encapsulation layer EN1 exposed by the groove GV may be surface-treated by the dry etching process to have a high surface roughness.

In a display device DD-2, the first insulating encapsulation layer EN1 and the lower insulating layers L-INS may extend to the edge of the substrate SUB. In addition, the first insulating encapsulation layer EN1 may include a first upper surface US1, which is not covered by the upper insulating layer U-INS and has a first surface roughness, and a second upper surface US2 which is covered by the upper insulating layer U-INS and has a second surface roughness. The first surface roughness is greater than the second surface roughness. The cover layer COV may be in contact with the first upper surface US1 of the first insulating encapsulation layer EN1.

The third insulating encapsulation layer EN3, the base insulating layer BSL, and the touch insulating layer T-INS may be spaced and/or apart (e.g., spaced apart or separated) from the edge of the substrate SUB and overlap the upper insulating layer U-INS. The edges of the third insulating encapsulation layer EN3, the base insulating layer BSL, and the touch insulating layer T-INS may overlap the edge of the upper insulating layer U-INS.

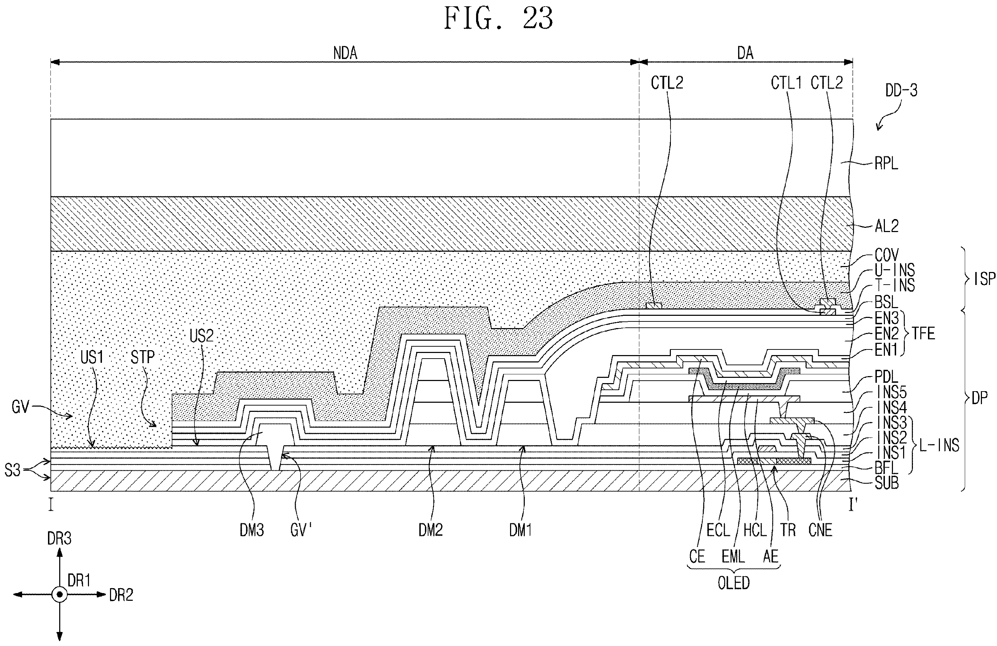

Referring to FIG. 23, as described in FIG. 19A, the lower insulating layers L-INS, the first and third insulating encapsulation layers EN1 and EN3, the base insulating layer BSL, and the touch insulating layer T-INS may extend up to the unit cutting line U-CL. Hereafter, through the dry etching process described in FIG. 19B, a portion of the touch insulating layer T-INS, a portion of the base insulating layer BSL, and portions of the first and third insulating encapsulation layers EN1 and EN3, which are exposed by the groove GV, are removed, and then, an upper surface of the third insulating layer INS3 exposed by the groove GV may be surface-treated by the dry etching process to have a high surface roughness.

The third insulating layer INS3, the first and second insulating layers INS1 and INS2, and the buffer layer BFL of a display device DD-3 may extend to the edge of the substrate SUB. In addition, the third insulating layer INS3 may include a first upper surface US1, which is not covered by the upper insulating layer U-INS and has a first surface roughness, and a second upper surface US2 which is covered by the upper insulating layer U-INS and has a second surface roughness. The first surface roughness is greater than the second surface roughness. The cover layer COV may be in contact with the first upper surface US1 of the third insulating layer INS3.

The insulating layers EN1, EN3, BSL, and T-INS arranged above the third insulating layer INS3 may be spaced and/or apart (e.g., spaced apart or separated) from the edge of the substrate SUB and overlap the upper insulating layer U-INS. The edges of the insulating layers EN1, EN3, BSL, and T-INS may overlap the edge of the upper insulating layer U-INS.

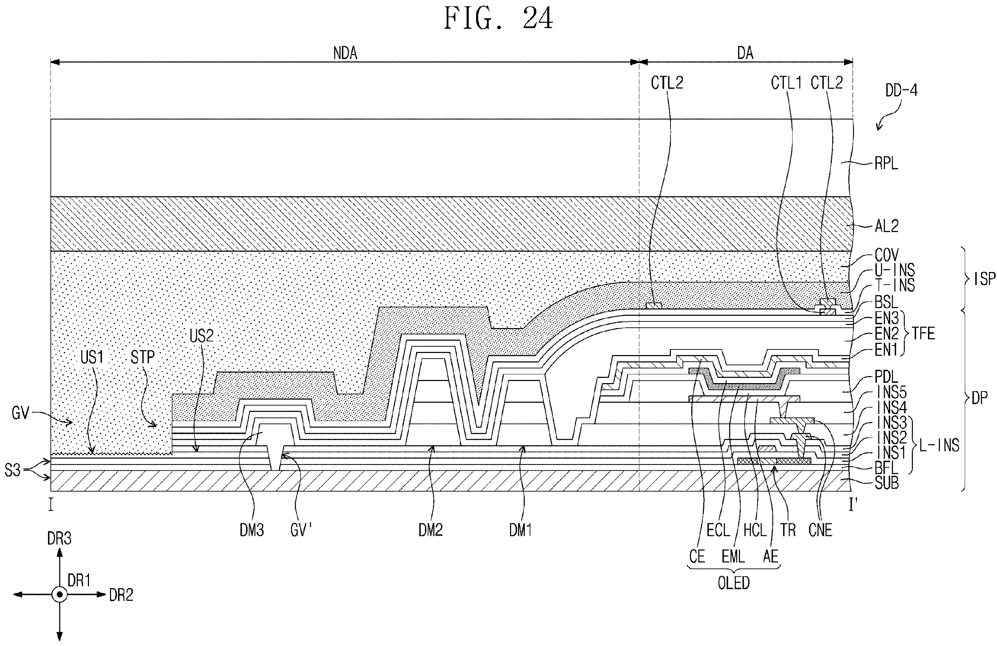

Referring to FIG. 24, as described in FIG. 19A, the lower insulating layers L-INS, the first and third insulating encapsulation layers EN1 and EN3, the base insulating layer BSL, and the touch insulating layer T-INS may extend up to the unit cutting line U-CL. Hereafter, through the dry etching process described in FIG. 19B, a portion of the touch insulating layer T-INS, a portion of the base insulating layer BSL, portions of the first and third insulating encapsulation layers EN1 and EN3, and a portion of the third insulating layer INS3, which are exposed by the groove GV, are removed, and then, an upper surface of the second insulating layer INS2 exposed by the groove GV may be surface-treated by the dry etching process to have a high surface roughness.

The second insulating layer INS2, the first insulating layer INS1, and the buffer layer BFL of a display device DD-4 may extend to the edge of the substrate SUB. In addition, the second insulating layer INS2 may include a first upper surface US1, which is not covered by the upper insulating layer U-INS and has a first surface roughness, and a second upper surface US2 which is covered by the upper insulating layer U-INS and has a second surface roughness. The first surface roughness is greater than the second surface roughness. The cover layer COV may be in contact with the first upper surface US1 of the second insulating layer INS2.

The insulating layers INS3, EN1, EN3, BSL, and T-INS arranged above the second insulating layer INS2 may be spaced and/or apart (e.g., spaced apart or separated) from the edge of the substrate SUB and overlap the upper insulating layer U-INS. The edges of the insulating layers INS3, EN1, EN3, BSL, and T-INS may overlap the edge of the upper insulating layer U-INS.

As examples, FIG. 23 and FIG. 24 respectively describe a structure in which the third insulating layer INS3 includes a first upper surface US1 and a second upper surface US2 and a structure in which the second insulating layer INS2 includes a first upper surface US1 and a second upper surface US2. However, embodiments of the present disclosure are not limited thereto, for example, in one or more embodiments, the first insulating layer INS1 may include a first upper surface US1 and a second upper surface US2, or the buffer layer BFL may include a first upper surface US1 and a second upper surface US2.

If (e.g., when) the first insulating layer INS1 includes the first upper surface US1 and the second upper surface US2, the first insulating layer INS1 and the buffer layer BFL may extend to the edge of the substrate SUB. In addition, the insulating layers INS2, INS3, EN1, EN3, BSL, and T-INS arranged on the first insulating layer INS1 may be spaced and/or apart (e.g., spaced apart or separated) from the edge of the substrate SUB and overlap the upper insulating layer U-INS, and the edges of the insulating layers INS2, INS3, EN1, EN3, BSL, and T-INS may overlap the edge of the upper insulating layer U-INS. The cover layer COV may be in contact with the first upper surface US1 of the first insulating layer INS1.

If (e.g., when) the buffer layer BFL includes the first upper surface US1 and the second upper surface US2, the buffer layer BFL may extend to the edge of the substrate SUB. In addition, the insulating layers INS1 to INS3, EN1, EN3, BSL, and T-INS arranged on the buffer layer BFL may be spaced and/or apart (e.g., spaced apart or separated) from the edge of the substrate SUB and overlap the upper insulating layer U-INS, and the edges of the insulating layers INS1 to INS3, EN1, EN3, BSL, and T-INS may overlap the edge of the upper insulating layer U-INS. The cover layer COV may be in contact with the first upper surface US1 of the buffer layer BFL.

Based on the lower insulating layers L-INS described above, according to one or more embodiments of the present disclosure, one lower insulating layer of (e.g., selected from among) the lower insulating layers BFL and INS1 to INS3 may extend to the edge of the substrate SUB and include a first upper surface US1 and a second upper surface US2. In these embodiments, insulating layers arranged on the one lower insulating layer among the lower insulating layers L-INS, the insulating encapsulation layers EN1 and EN3, the base insulating layer BSL, and the touch insulating layer T-INS may be spaced and/or apart (e.g., spaced apart or separated) from the edge of the substrate SUB and overlap the upper insulating layer U-INS, and the edges of the insulating layers arranged on the one lower insulating layer may overlap the edge of the upper insulating layer U-INS.

Referring to FIG. 25, as described in FIG. 19A, the lower insulating layers L-INS, the first and third insulating encapsulation layers EN1 and EN3, the base insulating layer BSL, and the touch insulating layer T-INS may extend up to the unit cutting line U-CL. Hereafter, through the dry etching process described in FIG. 19B, a portion of the touch insulating layer T-INS, a portion of the base insulating layer BSL, portions of the first and third insulating encapsulation layers EN1 and EN3, and portions of the lower insulating layers L-INS, which are exposed by the groove GV, are removed, and then, an upper surface of the substrate SUB exposed by the groove GV may be surface-treated through the dry etching process to have a high surface roughness.

The substrate SUB may include a first upper surface US1, which is not covered by the upper insulating layer U-INS and has a first surface roughness, and a second upper surface US2 which is covered by the upper insulating layer U-INS and has a second surface roughness. The first surface roughness is greater than the second surface roughness. The cover layer COV may be in contact with the first upper surface US1 of the substrate SUB.

The lower insulating layers L-INS, the insulating encapsulation layers EN1 and EN3, the base insulating layer BSL, and the touch insulating layer T-INS of a display device DD-5 may be spaced and/or apart (e.g., spaced apart or separated) from the edge of the substrate SUB and overlap the upper insulating layer U-INS. The edges of the lower insulating layers L-INS, the insulating encapsulation layers EN1 and EN3, the base insulating layer BSL, and the touch insulating layer T-INS may overlap the edge of the upper insulating layer U-INS.

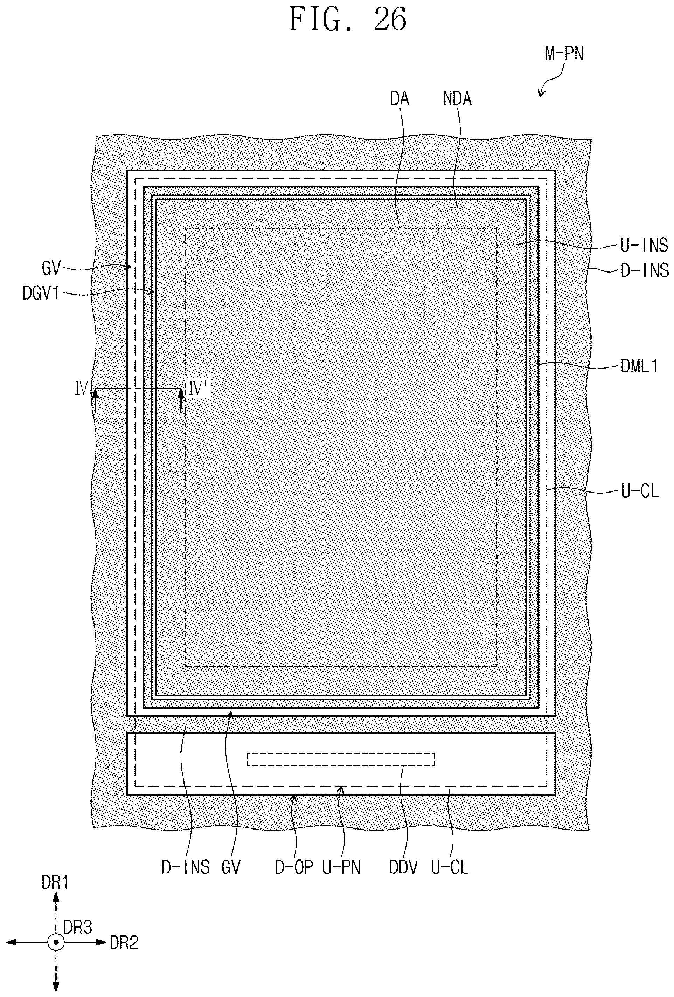

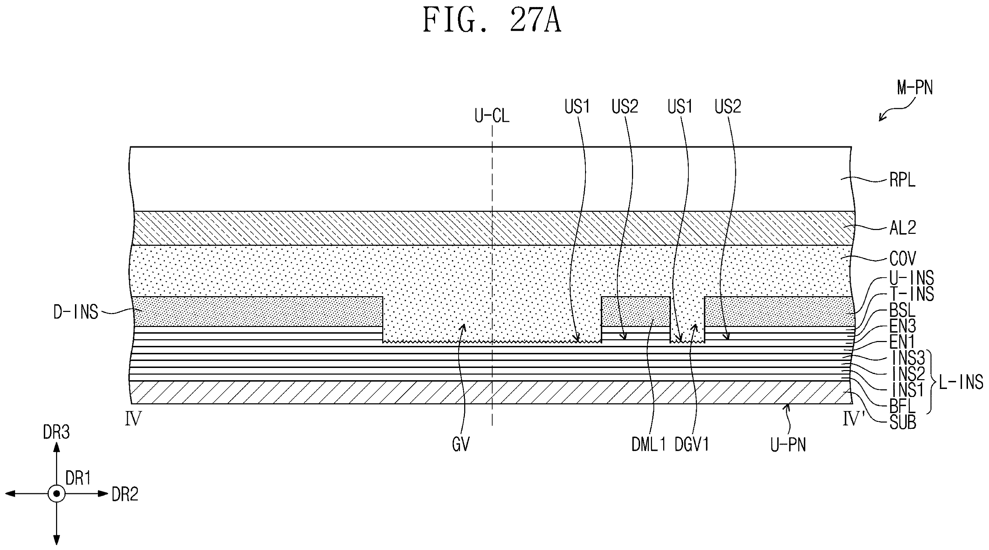

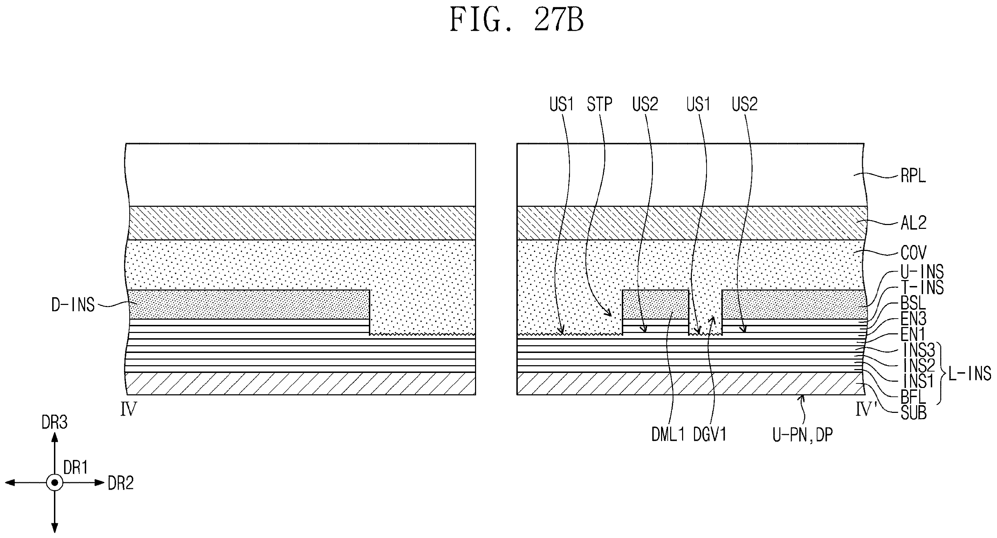

FIG. 26 illustrates a configuration on a unit panel according to one or more embodiments of the present disclosure. FIG. 27A is a cross-sectional view taken along the line IV-IV' illustrated in FIG. 26 according to one or more embodiments. FIG. 27B illustrates a unit panel formed by cutting along the cutting line illustrated in FIG. 27A.

As an example, FIG. 26 is illustrated as a plan view corresponding to FIG. 18, and FIGS. 27A and 27B are illustrated as cross-sectional views corresponding to FIGS. 19C and 19D, respectively. Hereinafter, the components illustrated in FIGS. 26, 27A, and 27B will be described with a focus on components different from those illustrated in FIGS. 18, 19C, and 19D.

Referring to FIG. 26, a first dam layer DML1 may be arranged on a unit panel U-PN. When viewed on a plane (e.g., in plan view), the first dam layer DML1 may be around (e.g., surround) the upper insulating layer U-INS. When viewed on a plane (e.g., in plan view), the first dam layer DML1 may be around (e.g., surround) the display region DA. When viewed on a plane (e.g., in plan view), the dummy insulating layer D-INS may be around (e.g., surround) the first dam layer DML1.

A groove GV may be defined between the dummy insulating layer D-INS and the first dam layer DML1. The groove GV may be defined to be around (e.g., surround) the first dam layer DML1. A first dummy groove DGV1 may be defined between the first dam layer DML1 and the upper insulating layer U-INS.

Referring to FIG. 27A, the first dam layer DML1 may be arranged at a same layer as the upper insulating layer U-INS. The first dam layer DML1 and the upper insulating layer U-INS may be concurrently (e.g., simultaneously) formed of a same material.

Through the dry etching process described in FIG. 19B, a first upper surfaces US1 of the third insulating encapsulation layer EN3 exposed by the groove GV and the first dummy groove DGV1 may have a first surface roughness. A second upper surfaces US2 of the third insulating encapsulation layer EN3 covered by the first dam layer DML1 and the upper insulating layer U-INS may have a second surface roughness. The first surface roughness is greater than the second surface roughness.

Referring to FIG. 27B, after cutting, the unit panel U-PN may be separated by the unit cutting line U-CL to form a display panel DP. The first dam layer DML1 may be arranged on the display panel DP, and the first dam layer DML1 may be spaced and/or apart (e.g., spaced apart or separated) from the edge of the display panel DP. The first dam layer DML1 may be arranged between the edge of the display panel DP and the upper insulating layer U-INS.

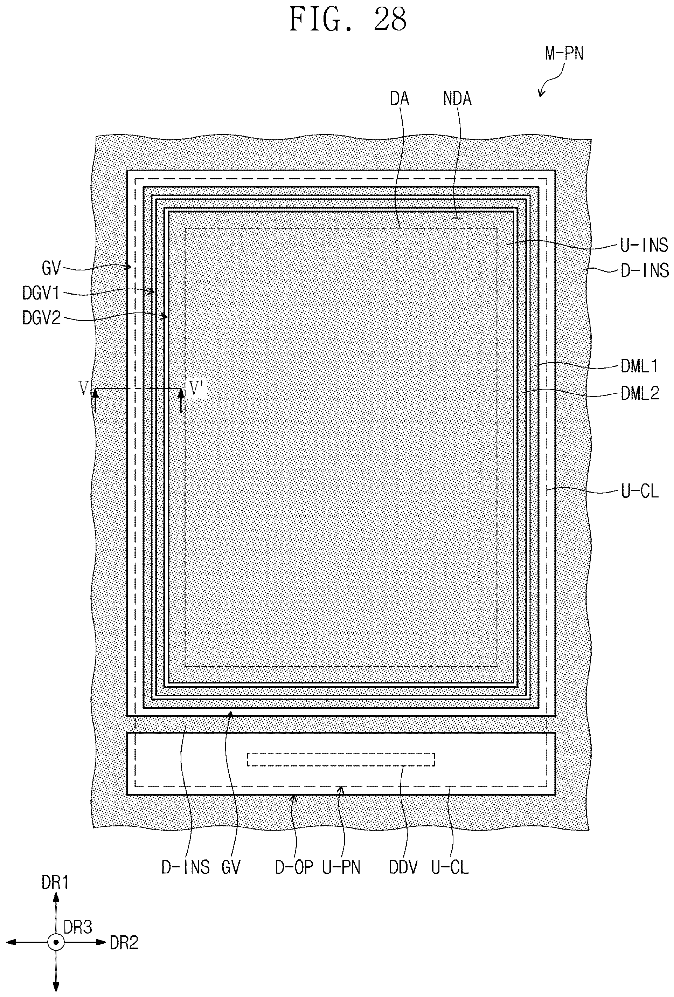

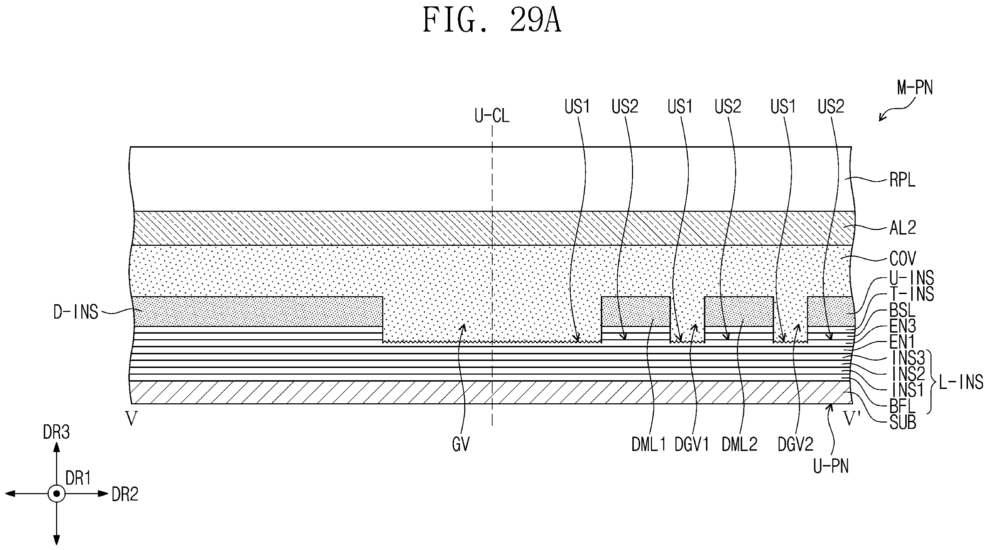

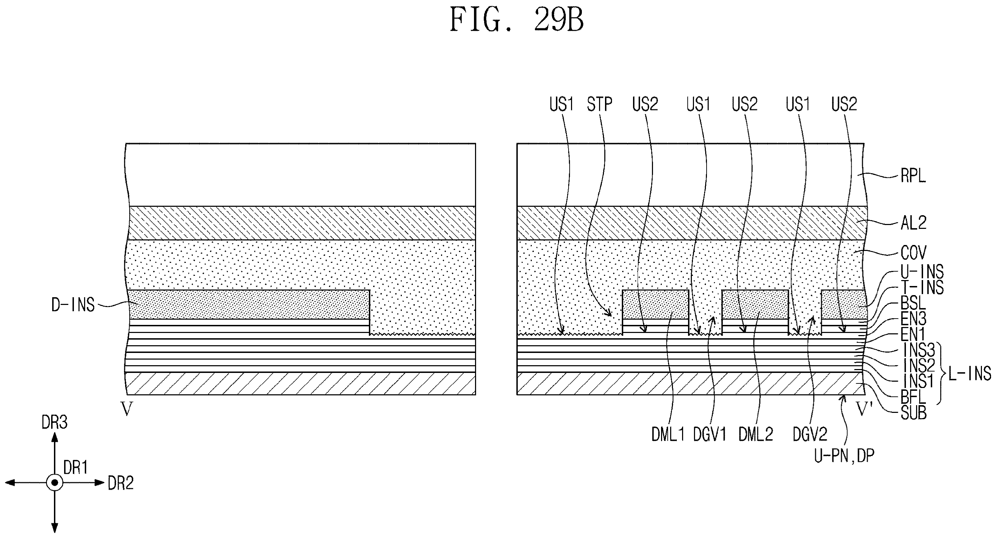

FIG. 28 illustrates a configuration on a unit panel according to one or more embodiments of the present disclosure. FIG. 29A is a cross-sectional view taken along the line V-V' illustrated in FIG. 28 according to one or more embodiments. FIG. 29B illustrates a unit panel formed by cutting along the cutting line illustrated in FIG. 29A.

As an example, FIG. 28 is illustrated as a plan view corresponding to FIG. 18, and FIGS. 29A and 29B are illustrated as cross-sectional views corresponding to FIGS. 19C and 19D, respectively. Hereinafter, the components illustrated in FIGS. 28, 29A, and 29B will be described with a focus on components different from those illustrated in FIGS. 18, 19C, and 19D.

Referring to FIG. 28, a first dam layer DML1 and a second dam layer DML2 may be arranged on the unit panel U-PN. When viewed on a plane (e.g., in plan view), the first dam layer DML1 may be around (e.g., surround) the second dam layer DML2. When viewed on a plane (e.g., in plan view), the second dam layer DML2 may be around (e.g., surround) the upper insulating layer U-INS. When viewed on a plane (e.g., in plan view), the second dam layer DML2 may be around (e.g., surround) the display region DA. When viewed on a plane (e.g., in plan view), the dummy insulating layer D-INS may be around (e.g., surround) the first dam layer DML1.

A groove GV may be defined between the dummy insulating layer D-INS and the first dam layer DML1. A first dummy groove DGV1 may be defined between the first dam layer DML1 and the second dam layer DML2. A second dummy groove DGV2 may be defined between the second dam layer DML2 and the upper insulating layer U-INS.

Referring to FIG. 29A, the first dam layer DML1 and the second dam layer DML2 may be arranged at a same layer as the upper insulating layer U-INS. The first dam layer DML1, the second dam layer DML2, and the upper insulating layer U-INS may be concurrently (e.g., simultaneously) formed of a same material.

Through the dry etching process described in FIG. 19B, a first upper surfaces US1 of the third insulating encapsulation layer EN3 exposed by the groove GV, the first dummy groove DGV1, and the second dummy groove DGV2 may have a first surface roughness. A second upper surfaces US2 of the third insulating encapsulation layer EN3 covered by the first dam layer DML1, the second dam layer DML2, and the upper insulating layer U-INS may have a second surface roughness. The first surface roughness is greater than the second surface roughness.

Referring to FIG. 29B, after cutting, the unit panel U-PN may be separated by the unit cutting line U-CL to form a display panel DP. The first dam layer DML1 and the second dam layer DML2 may be arranged on the display panel DP, and the first dam layer DML1 and the second dam layer DML2 may be spaced and/or apart (e.g., spaced apart or separated) from the edge of the display panel DP. The first dam layer DML1 and the second dam layer DML2 may be arranged between the edge of the display panel DP and the upper insulating layer U-INS. The second dam layer DML2 may be arranged between the first dam layer DML1 and the upper insulating layer U-INS.

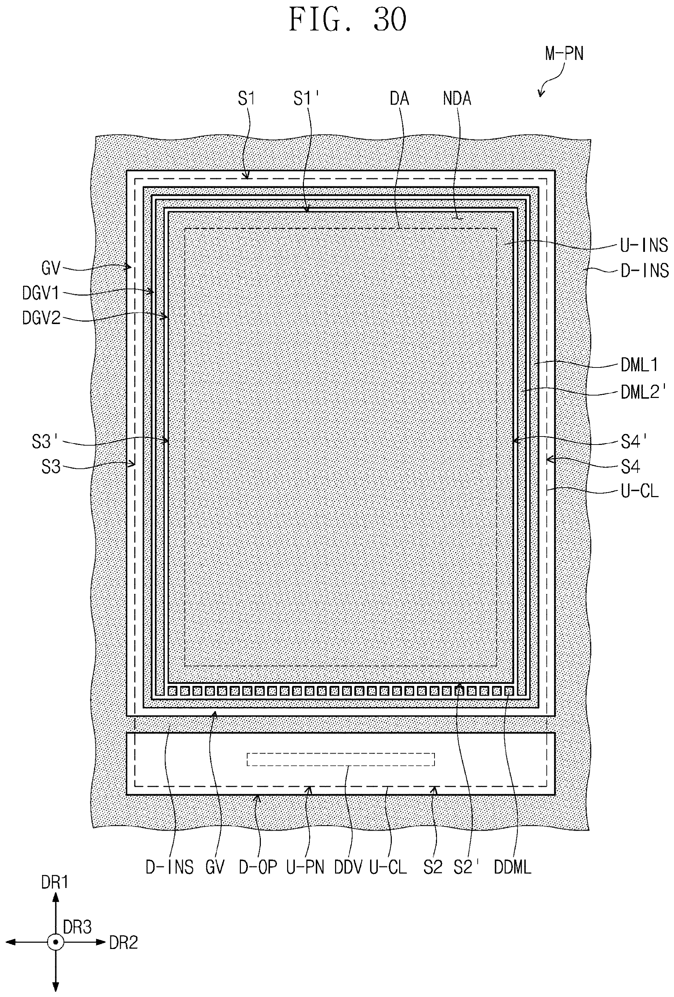

FIG. 30 illustrates a configuration on a unit panel according to one or more embodiments of the present disclosure.

As an example, FIG. 30 illustrates a plan view corresponding to FIG. 28. Hereinafter, the components illustrated in FIG. 30 will be described with a focus on components different from those illustrated in FIG. 28.

Referring to FIG. 30, a second dam layer DML2' may be arranged adjacent to the first side S1', the third side S3', and the fourth side S4' of the upper insulating layer U-INS. A plurality of dummy dam layers DDML may be arranged between the second side S2' of the upper insulating layer U-INS and the first dam layer DML1. The dummy dam layers DDML may be arranged in the second direction DR2.

According to one or more embodiments of the present disclosure, the side surface of the upper insulating layer of the input sensing unit may be spaced and/or apart (e.g., spaced apart or separated) from the edge of the display panel, and the cover layer may be arranged on the display panel so as to cover the side surface of the upper insulating layer. Because the cover layer absorbs an external impact, the external impact applied to the upper insulating layer may be reduced.

For example, the side surface of the upper insulating layer of the input sensing unit may be spaced from the edge of the display panel, and the cover layer may be arranged on the display panel to cover the side surface of the upper insulating layer. Because the cover layer absorbs external impacts, the impact applied to the upper insulating layer may be reduced.

In addition, an insulating layer arranged below the upper insulating layer may extend to the edge of the substrate, and the surface roughness of the first upper surface of the insulating layer, which is not covered by the upper insulating layer, may be increased via a dry etching process. As the cover layer is in contact with the first upper surface having increased surface roughness, the adhesive force between the cover layer and the first upper surface may improve. Accordingly, because the cover layer is more firmly attached to the insulating layer, the cover layer and the insulating layer may not be separated from each other by an external impact.

Furthermore, the arrangement of the insulating layers and the cover layer as described ensures that the display device is capable of withstanding external impacts more effectively. By spacing the upper insulating layer apart from the edge of the substrate and increasing the surface roughness of the exposed insulating layer, the adhesive force between the cover layer and the insulating layer is enhanced. This configuration prevents or reduce delamination and separation of the layers, thereby improving the durability and reliability of the display device.

In the present disclosure, expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof.

As utilized herein, the terms "substantially," "about," "approximately," or similar terms are used as terms of approximation and not as terms of degree, and are intended to account for the inherent deviations in measured or calculated values that would be recognized by those of ordinary skill in the art. "About" or "approximately" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" or "approximately" may mean within one or more standard deviations, or within ± 30%, 20%, 10%, or 5% of the stated value.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

The light emitting element, the display panel, the display device, the electronic devices/apparatus, device-manufacturing apparatus, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

Although the above has been described with reference to example embodiments of the disclosure, those skilled in the art or those of ordinary skill in the art will understand that one or more suitable modifications and changes can be made to the disclosure within the scope that does not depart from the technical field of the disclosure described in the appended claims.

Accordingly, the technical scope of the disclosure should not be limited to the content described in the detailed description of the disclosure, but should be determined by the appended claims and equivalents thereof.

Embodiments are set out in the following clauses:
Clause 1. A display device comprising:
   a substrate;
   a plurality of lower insulating layers on the substrate;
   a light-emitting element on the lower insulating layers;
   an encapsulation layer on the light-emitting element, the encapsulation layer comprising a plurality of insulating encapsulation layers;
   a base insulating layer on the encapsulation layer;
   a conductive pattern on the base insulating layer; and
   an upper insulating layer on the conductive pattern,
   wherein:
      the upper insulating layer is spaced from an edge of the substrate;
      at least one insulating layer, selected from among the lower insulating layers, the insulating encapsulation layers, and the base insulating layer, extends to the edge of the substrate; and
      a first surface roughness of a first upper surface of the at least one insulating layer, which is exposed upward without being covered by the upper insulating layer, is greater than a second surface roughness of a second upper surface of the at least one insulating layer covered by the upper insulating layer.
Clause 2. The display device of clause 1, further comprising a cover layer on the upper insulating layer,
   wherein the cover layer extends to the edge of the substrate.
Clause 3. The display device of clause 2, wherein the cover layer is in contact with the first upper surface.
Clause 4. The display device of clause 2 or clause 3, wherein each of the upper insulating layer and the cover layer comprises an organic insulating layer.
Clause 5. The display device of any one of clauses 1 to 4, wherein a difference between the first surface roughness and the second surface roughness is about 10 nm to about 70 nm.
Clause 6. The display device of clause 5, wherein the first surface roughness is about 30 nm to about 70 nm, and the second surface roughness is about 1 nm to about 20 nm.
Clause 7. The display device of any one of clauses 1 to 6, further comprising a transistor between the lower insulating layers and connected to the light-emitting element.
Clause 8. The display device of any one of clauses 1 to 7, wherein:
   the lower insulating layers and the encapsulation layer extend to the edge of the substrate;
   the base insulating layer is spaced from the edge of the substrate and overlaps the upper insulating layer; and
   an edge of the base insulating layer overlaps an edge of the upper insulating layer.
Clause 9. The display device of clause 8, further comprising a touch insulating layer on the base insulating layer,
   wherein the conductive pattern comprises:
   a first conductive pattern; and
   a second conductive pattern on the first conductive pattern, and
   wherein:
      the touch insulating layer is on the first conductive pattern;
      the second conductive pattern is on the touch insulating layer;
      the upper insulating layer is on the second conductive pattern;
      the touch insulating layer is spaced from the edge of the substrate and overlaps the upper insulating layer; and
      an edge of the touch insulating layer overlaps the edge of the upper insulating layer.
Clause 10. The display device of clause 8 or clause 9, wherein an uppermost insulating encapsulation layer among the insulating encapsulation layers comprises the first upper surface and the second upper surface.
Clause 11. The display device of any one of clauses 8 to 10, wherein the insulating encapsulation layers comprise:
   a first insulating encapsulation layer;
   a second insulating encapsulation layer on the first insulating encapsulation layer; and
   a third insulating encapsulation layer on the second insulating encapsulation layer, and
   wherein the second insulating encapsulation layer comprises an organic insulating layer, and the first and third insulating encapsulation layers each comprise an inorganic insulating layer.
Clause 12. The display device of clause 11, wherein:
   the first and third insulating encapsulation layers extend to the edge of the substrate; and
   the third insulating encapsulation layer comprises the first upper surface and the second upper surface.
Clause 13. The display device of clause 11, wherein:
   the first insulating encapsulation layer extends to the edge of the substrate;
   the first insulating encapsulation layer comprises the first upper surface and the second upper surface;
   the third insulating encapsulation layer is spaced from the edge of the substrate and overlaps the upper insulating layer; and
   an edge of the third insulating encapsulation layer overlaps the edge of the upper insulating layer.
Clause 14. The display device of any one of clauses 8 to 13, wherein each of the lower insulating layers and the base insulating layer comprises an inorganic insulating layer.
Clause 15. The display device of any one of clauses 1 to 14, wherein a distance between the edge of the substrate and an edge of the upper insulating layer is about 40 µm to about 120 µm.
Clause 16. The display device of any one of clauses 1 to 9, wherein the base insulating layer extends to the edge of the substrate and comprises the first upper surface and the second upper surface.
Clause 17. The display device of any one of clauses 1 to 9, wherein:
   one lower insulating layer selected from among the lower insulating layers extends to the edge of the substrate and comprises the first upper surface and the second upper surface;
   insulating layers arranged on the one lower insulating layer among the lower insulating layers, the insulating encapsulation layers, and the base insulating layer are spaced from the edge of the substrate and overlap the upper insulating layer; and
   edges of the insulating layers arranged on the one lower insulating layer overlap an edge of the upper insulating layer.
Clause 18. The display device of any one of clauses 1 to 17, further comprising a dummy insulating layer between the upper insulating layer and a lower side of the substrate in plan view,
   wherein:
   the dummy insulating layer is arranged at a same layer as the upper insulating layer;
   a groove is defined between the dummy insulating layer and the upper insulating layer; and
   a third surface roughness of a third upper surface of the at least one insulating layer exposed by the groove is equal to the first surface roughness and greater than the second surface roughness.
Clause 19. The display device of any one of clauses 1 to 18, further comprising at least one dam layer between the edge of the substrate and the upper insulating layer,
   wherein the at least one dam layer is at a same layer as the upper insulating layer;
   a dummy groove is defined between the at least one dam layer and the upper insulating layer; and
   an upper surface of the at least one insulating layer exposed by the dummy groove has the first surface roughness.
Clause 20. The display device of any one of clauses 1 to 19, wherein the first upper surface is surface-treated by a dry etching process.
Clause 21. A display device comprising:
   a substrate;
   a plurality of lower insulating layers on the substrate;
   a light-emitting element on the lower insulating layers;
   an encapsulation layer on the light-emitting element and comprising a plurality of insulating encapsulation layers;
   a base insulating layer on the encapsulation layer;
   a conductive pattern on the base insulating layer; and
   an upper insulating layer on the conductive pattern,
   wherein:
      the upper insulating layer, the lower insulating layers, the insulating encapsulation layers, and the base insulating layer are spaced from an edge of the substrate;
      edges of the upper insulating layer, the lower insulating layers, the insulating encapsulation layers, and the base insulating layer overlap one another; and
      a first surface roughness of a first upper surface of the substrate, which is exposed upward without being covered by the upper insulating layer, is greater than a second surface roughness of a second upper surface of the substrate covered by the upper insulating layer.
Clause 22. The display device of clause 21, further comprising a cover layer on the upper insulating layer,
   wherein the cover layer extends to the edge of the substrate and is in contact with the first upper surface.
Clause 23. An electronic device comprising:
   a display device; and
   a processor for processing an image signal and providing the image signal to the display device,
   wherein the display device comprises:
      a substrate;
      a plurality of lower insulating layers on the substrate;
      a light-emitting element on the lower insulating layers;
      an encapsulation layer on the light-emitting element and comprising a plurality of insulating encapsulation layers;
      a base insulating layer on the encapsulation layer;
      a conductive pattern on the base insulating layer; and
      an upper insulating layer on the conductive pattern, and
      wherein:
         the upper insulating layer is spaced from an edge of the substrate;
         at least one insulating layer, selected from among the lower insulating layers, the insulating encapsulation layers, and the base insulating layer, extends to the edge of the substrate; and
         a first surface roughness of a first upper surface of the at least one insulating layer, which is exposed upward without being covered by the upper insulating layer, is greater than a second surface roughness of a second upper surface of the at least one insulating layer covered by the upper insulating layer.

## Claims

1. A display device (DD) comprising:
a substrate (SUB);
a plurality of lower insulating layers (BFL, INS1, INS2, INS3) on the substrate (SUB);
a light-emitting element (OLED) on the lower insulating layers (BFL, INS1, INS2, INS3);
an encapsulation layer (TFE) on the light-emitting element (OLED), the encapsulation layer (TFE) comprising a plurality of insulating encapsulation layers (EN1, EN2, EN3);
a base insulating layer (BSL) on the encapsulation layer (TFE);
a conductive pattern (CTL) on the base insulating layer (BSL); and
an upper insulating layer (U-INS) on the conductive pattern (CTL),
wherein:
the upper insulating layer (U-INS) is spaced from an edge of the substrate (SUB);
at least one insulating layer, selected from among the lower insulating layers (BFL, INS1, INS2, INS3), the insulating encapsulation layers (EN1, EN2, EN3), and the base insulating layer (BSL), extends to the edge of the substrate (SUB); and
a first surface roughness of a first upper surface (US1) of the at least one insulating layer, which is exposed upward without being covered by the upper insulating layer (U-INS), is greater than a second surface roughness of a second upper surface (US2) of the at least one insulating layer covered by the upper insulating layer (U-INS).

2. The display device (DD) of claim 1, further comprising a cover layer (COV) on the upper insulating layer (U-INS),
wherein the cover layer (COV) extends to the edge of the substrate (SUB).

3. The display device (DD) of claim 2, wherein:
(i) the cover layer (COV) is in contact with the first upper surface (US1); and/or
(ii) each of the upper insulating layer (U-INS) and the cover layer (COV) comprises an organic insulating layer.

4. The display device (DD) of any one of claims 1 to 3, wherein a difference between the first surface roughness and the second surface roughness is about 10 nm to about 70 nm, optionally wherein the first surface roughness is about 30 nm to about 70 nm, and the second surface roughness is about 1 nm to about 20 nm.

5. The display device (DD) of any one of claims 1 to 4, further comprising a transistor (TR) between the lower insulating layers (BFL, INS1, INS2, INS3) and connected to the light-emitting element (OLED).

6. The display device (DD) of any one of claims 1 to 5, wherein:
the lower insulating layers (BFL, INS1, INS2, INS3) and the encapsulation layer (TFE) extend to the edge of the substrate (SUB);
the base insulating layer (BSL) is spaced from the edge of the substrate (SUB) and overlaps the upper insulating layer (U-INS); and
an edge of the base insulating layer (BSL) overlaps an edge of the upper insulating layer (U-INS).

7. The display device (DD) of claim 6, further comprising a touch insulating layer (T-INS) on the base insulating layer (BSL),
wherein the conductive pattern (CTL) comprises:
a first conductive pattern (CTL1); and
a second conductive pattern (CTL2) on the first conductive pattern (CTL1), and
wherein:
the touch insulating layer (T-INS) is on the first conductive pattern (CTL1);
the second conductive pattern (CTL2) is on the touch insulating layer (T-INS);
the upper insulating layer (U-INS) is on the second conductive pattern (CTL2);
the touch insulating layer (T-INS) is spaced from the edge of the substrate (SUB) and overlaps the upper insulating layer (U-INS); and
an edge of the touch insulating layer (T-INS) overlaps the edge of the upper insulating layer (U-INS.

8. The display device of claim 6 or claim 7, wherein an uppermost insulating encapsulation layer (EN3) among the insulating encapsulation layers (EN1, EN2, EN3) comprises the first upper surface (US1) and the second upper surface (US2).

9. The display device (DD, DD-2) of any one of claims 6 to 8, wherein the insulating encapsulation layers (EN1, EN2, EN3) comprise:
a first insulating encapsulation layer (EN1);
a second insulating encapsulation layer (EN2) on the first insulating encapsulation layer (EN1); and
a third insulating encapsulation layer (EN3) on the second insulating encapsulation layer (EN2), and
wherein the second insulating encapsulation layer (EN2) comprises an organic insulating layer, and the first and third insulating encapsulation layers (EN1, EN3) each comprise an inorganic insulating layer, optionally wherein:
(i) the first and third insulating encapsulation layers (EN1, EN3) extend to the edge of the substrate (SUB); and
the third insulating encapsulation layer (EN3) comprises the first upper surface (US1) and the second upper surface (US2); or
(ii) the first insulating encapsulation layer (EN1) extends to the edge of the substrate (SUB);
the first insulating encapsulation layer (EN1) comprises the first upper surface (US1) and the second upper surface (US2);
the third insulating encapsulation layer (EN3) is spaced from the edge of the substrate (SUB) and overlaps the upper insulating layer (U-INS); and
an edge of the third insulating encapsulation layer (EN3) overlaps the edge of the upper insulating layer (U-INS).

10. The display device (DD) of any one of claims 6 to 9, wherein each of the lower insulating layers (BFL, INS1, INS2, INS3) and the base insulating layer (BSL) comprises an inorganic insulating layer.

11. The display device (DD) of any one of claims 1 to 10, wherein a distance between the edge of the substrate (SUB) and an edge of the upper insulating layer (U-INS) is about 40 µm to about 120 µm.

12. The display device (DD-1) of any one of claims 1 to 7, wherein:
(i) the base insulating layer (BSL) extends to the edge of the substrate (SUB) and comprises the first upper surface (US1) and the second upper surface (US2); or
(ii) one lower insulating layer selected from among the lower insulating layers (BFL, INS1, INS2, INS3) extends to the edge of the substrate (SUB) and comprises the first upper surface (US1) and the second upper surface (US2);
insulating layers arranged on the one lower insulating layer among the lower insulating layers (BFL, INS1, INS2, INS3), the insulating encapsulation layers (EN1, EN2, EN3), and the base insulating layer (BSL) are spaced from the edge of the substrate (SUB) and overlap the upper insulating layer (U-INS); and
edges of the insulating layers arranged on the one lower insulating layer overlap an edge of the upper insulating layer (U-INS).

13. The display device (DD) of any one of claims 1 to 12, wherein:
(i) the display device (DD) further comprises a dummy insulating layer (D-INS) between the upper insulating layer (U-INS) and a lower side (S2) of the substrate (SUB) in plan view,
wherein:
the dummy insulating layer (D-INS) is arranged at a same layer as the upper insulating layer (U-INS);
a groove (GV) is defined between the dummy insulating layer (D-INS) and the upper insulating layer (U-INS); and
a third surface roughness of a third upper surface (US3) of the at least one insulating layer exposed by the groove (GV) is equal to the first surface roughness and greater than the second surface roughness; and/or
(ii) the display device (DD) further comprises at least one dam layer (DML1) between the edge of the substrate (SUB) and the upper insulating layer (U-INS),
wherein the at least one dam layer (DML1) is at a same layer as the upper insulating layer (U-INS);
a dummy groove (DGV1) is defined between the at least one dam layer (DML1) and the upper insulating layer (U-INS); and
an upper surface (US1) of the at least one insulating layer exposed by the dummy groove (DGV1) has the first surface roughness; and/or
(iii) the first upper surface (US1) is surface-treated by a dry etching process.

14. A display device (DD-5) comprising:
a substrate (SUB);
a plurality of lower insulating layers (BFL, INS1, INS2, INS3) on the substrate (SUB);
a light-emitting element (OLED) on the lower insulating layers (BFL, INS1, INS2, INS3);
an encapsulation layer (TFE) on the light-emitting element (OLED) and comprising a plurality of insulating encapsulation layers (EN1, EN2, EN3);
a base insulating layer (BSL) on the encapsulation layer (TFE);
a conductive pattern (CTL) on the base insulating layer (BSL); and
an upper insulating layer (U-INS) on the conductive pattern (CTL),
wherein:
the upper insulating layer (U-INS), the lower insulating layers (BFL, INS1, INS2, INS3), the insulating encapsulation layers (EN1, EN2, EN3), and the base insulating layer (BSL) are spaced from an edge of the substrate (SUB);
edges of the upper insulating layer (U-INS), the lower insulating layers (BFL, INS1, INS2, INS3), the insulating encapsulation layers (EN1, EN2, EN3), and the base insulating layer (BSL) overlap one another; and
a first surface roughness of a first upper surface (US1) of the substrate (SUB), which is exposed upward without being covered by the upper insulating layer (U-INS), is greater than a second surface roughness of a second upper surface (US2) of the substrate (SUB) covered by the upper insulating layer (U-INS), optionally further comprising a cover layer (COV) on the upper insulating layer (U-INS),
wherein the cover layer (COV) extends to the edge of the substrate (SUB) and is in contact with the first upper surface (US1).

15. An electronic device (ED) comprising:
a display device (DD); and
a processor (PRS) for processing an image signal and providing the image signal to the display device (DD),
wherein the display device (DD) comprises:
a substrate (SUB);
a plurality of lower insulating layers (BFL, INS1, INS2, INS3) on the substrate (SUB);
a light-emitting element (OLED) on the lower insulating layers (BFL, INS1, INS2, INS3);
an encapsulation layer (TFE) on the light-emitting element (OLED) and comprising a plurality of insulating encapsulation layers (EN1, EN2, EN3);
a base insulating layer (BSL) on the encapsulation layer (TFE);
a conductive pattern (CTL) on the base insulating layer (BSL); and
an upper insulating layer (U-INS) on the conductive pattern (CTL), and
wherein:
the upper insulating layer (U-INS) is spaced from an edge of the substrate (SUB);
at least one insulating layer, selected from among the lower insulating layers (BFL, INS1, INS2, INS3), the insulating encapsulation layers (EN1, EN2, EN3), and the base insulating layer (BSL), extends to the edge of the substrate (SUB); and
a first surface roughness of a first upper surface (US1) of the at least one insulating layer, which is exposed upward without being covered by the upper insulating layer (U-INS), is greater than a second surface roughness of a second upper surface (US2) of the at least one insulating layer covered by the upper insulating layer (U-INS).
